# EUROPEAN PATENT SPECIFICATION

(11) **EP 2 302 462 B1**
(45) Date of publication and mention of the grant of the patent: **27.12.2017**
(21) Application number: 10178709.1
(22) Date of filing: 23.09.2010
(51) Int. Cl.: G03F 7/32, B41C 1/00

(54) **Method of preparing a lithographic printing plate**
Verfahren zur Herstellung einer Lithographiedruckplatte
Procédé de préparation d'une plaque d'impression lithographique

(30) Priority: 24.09.2009 JP 2009219716
(43) Date of publication of application: 30.03.2011
(60) Divisional application: 16157103.9
(73) Proprietor: Fujifilm Corporation, Minato-ku Tokyo (JP)
(72) Inventor: Sato, Takashi, Shizuoka (JP); Inno, Toshifumi, Shizuoka (JP); Arimura, Keisuke, Shizuoka (JP); Taguchi, Yoshinori, Shizuoka (JP)
(74) Representative: Hoffmann Eitle

(56) References cited:
- EP-A1- 2 040 124
- EP-A1- 2 226 681
- EP-A1- 2 261 033
- EP-A2- 2 168 765
- WO-A1-2009/087862
- US-A- 3 615 480

## Description

### Background of the invention

### 1. Field of the Invention

The present invention relates to a method of preparing a lithographic printing plate.

2. Description of the Related Art In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

Thus, in the hitherto known plate making process of lithographic printing plate precursor, after exposure, the step of removing the unnecessary portion of the image-recording layer by dissolving, for example, with a developer is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous alkali solution having pH of 11 or more, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

In response to the above situation, for instance, a developing method of processing with a developer having pH of 8.5 to 11.5 and a dielectric constant of 3 to 30 mS/cm and containing an alkali metal carbonate and an alkali metal hydrogen carbonate is proposed in Patent Document 1. However, since the developing method is required a water-washing step and a treatment step with a gum solution, it does not resolve the problems of the environment and running cost.

Also, a processing with a processing solution having pH of 11.9 to 12.1 and containing a water-soluble polymer compound is described in the example of Patent Document 2. However, since the lithographic printing plate obtained by the processing is left in the state that the alkali of pH 12 adheres on the surface thereof, a problem in view of safety of an operator arises and also another problem occurs in that with the lapse of long time after the preparation of the lithographic printing plate until the initiation of printing, the image area gradually dissolves to result in deterioration in printing durability or ink-receptive property. In Patent Document 3, a processing with a processing solution having pH of 3 to 9 and containing a water-soluble polymer compound is described. However, since the processing solution does not contain a basic component, it is necessary to enable development by making a polymer used in the photosensitive layer hydrophilic and thus, a problem occurs in that printing durability severely degrades.

Since hitherto known development processing comprises three steps of developing with an aqueous strong alkali solution, washing of the alkali agent with a water-washing bath and then treating with a gum solution mainly comprising a hydrophilic resin as described above, the automatic developing machine has a large size, the amount of waste liquid is large and the running cost is high.

On the other hand, with respect to one step development with a developer other than a strongly alkaline developer, it has been desired to solve problems, for example, in that development scum occurs because the developing property is poor and in that printing durability of a lithographic printing plate obtained is not sufficient.

Patent Document 1: JP-A-11-65126 (the term "JP-A" as used herein means an "unexamined published Japanese patent application")

Patent Document 2: EP-A-1868036

Patent Document 3: JP-T-2007-538279 (the term "JP-T" as used herein means a published Japanese translation of a PCT patent application)

EP-A-2 261 033, prior art pursuant to Article 54(3) EPC, teaches a method for preparing a lithographic printing plate. The method comprises imagewise exposing a lithographic printing plate precursor comprising a support, an image-recording layer containing a polymerization initiator, a polymerizable compound and polyvinyl butyral and a protective layer containing polyvinyl alcohol in this order to cure an exposed area of the image-recording layer. Unexposed areas of the image-recording layer and the protective layer are then removed using a developing solution containing at least one of an alcohol having from 3 to 10 carbon atoms, a ketone having from 4 to 10 carbon atoms, a pyridine having from 5-10 carbon atoms, a phenol having from 6-10 carbon atoms and a thiocyanate of defined formula in an amount of 0.1 to 20% by weight thereby forming an image.

EP-A-2 168 765, prior art pursuant to Article 54(3) EPC, discloses a process for producing a lithographic printing plate comprising exposing a defined lithographic printing plate precursor and removing non-exposed portions of the photosensitive layer in the presence of a developer having buffering capacity. One example of a suitable developer comprises phenoxypropanol, octanol and the following two nonionic surfactants:

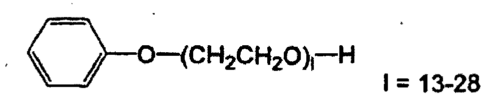

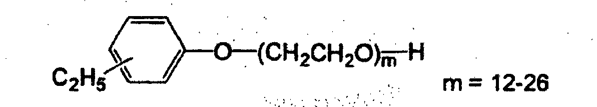

EP-A-2 226 681 teaches a method of preparing a lithographic printing plate comprising imagewise exposing a defined lithographic printing plate precursor and then removing unexposed areas of its photosensitive layer with a developer having a pH of 2 to 11. The developer may comprise the same four components as described above in the case the developer of EP-A-2 168 765.

WO-A-2009/087862 teaches the preparation of a lithographic printing plate from a defined precursor by imagewise irradiation followed by development with an aqueous processing solution having a pH of 3.2 and containing EDTA-Na₄. The processing solution may further comprise an alcohol such as octanol.

EP-A-2 040 124 discloses developing an exposed lithographic printing plate precursor with an aqueous alkaline developer comprising at least one alkylene oxide derivative of defined formula, and at least one of an alkaline component or a surfactant.

US-A-3 615 480 discloses an aqueous developer solution for removing unexposed areas of a photopolymerizable layer. The developer comprises a soluble lithium, sodium or potassium metal silicate and at least one water-miscible organic solvent selected from low-molecular-weight aliphatic alcohols, ketones and ethers having a chain structure of 1 to 4 carbon atoms in addition to the functional groups. The developer solution has a pH in the range 10-13.

### Summary of the Invention

A photosensitive layer containing a hexaarylbisimidazole compound which is a polymerization initiator and a polymerizable compound having a hydrocarbon group having 6 or more carbon atoms in its molecule provides high printing durability but is very poor in solubility or dispersibility in a developer of an acidic to weak alkaline range. Thus, in a development processing of a lithographic printing plate precursor comprising the photosensitive layer containing such compounds, as the amount of development processing increases and the amount of the component dissolved in the developer increases, the solubility or dispersibility is deteriorated so that development scum and stickiness of the processing bath or the plate surface after the processing are easily apt to occur. Although the solubility or dispersibility may be increased by adding an organic solvent to the developer, odor sometimes causes a problem when the developer attached to the lithographic printing plate precursor is dried without performing a water washing step.

An object of the present invention is to provide a method of preparing a lithographic printing plate which prevents the occurrence of development scum, achieves a balance between good developing property and good printing durability, and is free from the odor generation, even when development with a developer of an acidic to weak alkaline range is conducted.

According to the present invention there is provided a method of preparing a lithographic printing plate which comprises:
exposing imagewise a lithographic printing plate precursor comprising a hydrophilic support having provided thereon a photosensitive layer containing (A) a hexaarylbisimidazole compound, (B) a polymerizable compound having a hydrocarbon group having 6 or more carbon atoms in its molecule, (C) a sensitizing dye and (D) a binder polymer and a protective layer in this order using a laser, and
removing the protective layer and an unexposed area of the photosensitive layer of the exposed lithographic printing plate precursor using a processing solution having pH of 2 to 11 and which contains (E) an alcohol represented by formula (I) and (F) a compound represented by formula (III): 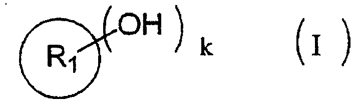
wherein R₁ represents a k-valent straight-chain, branched or cyclic aliphatic hydrocarbon group having from 9 to 12 carbon atoms, and k represents an integer of 1 or more; 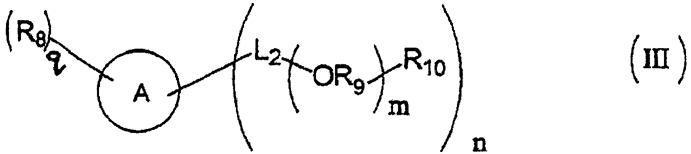 wherein A represents an aromatic ring, R₈ represents an alkyl group having from 1 to 3 carbon atoms, L₂ represents a single bond or an alkylene group having from 1 to 4 carbon atoms, R₉ represents an alkylene group having from 1 to 4 carbon atoms, R₁₀ represents a hydroxy group, an alkoxy group having from 1 to 4 carbon atoms, a phenoxy group or a naphthoxy group, m represents an integer of 0 to 4, q represents an integer of 0 to 5, and n represents an integer of 1 to 8, provided that q and n satisfy 1≤q+n≤8.

Preferably R₉ is an alkylene group having 1 or 2 carbon atoms, or m represents an integer of 2 to 4.

Preferably the processing solution further comprises a nonionic surfactant.

Preferably the weight ratio of compound (E) to the compound (F) is from 1:9 to 9:1.

Preferably the processing solution further comprises carbonate ions and hydrogen carbonate ions.

Preferably the processing solution further comprises a water-soluble organic amine compound or an ion thereof. In this case, the water-soluble organic amine compound is monoethanolamine, diethanolamine, triethanolamine, N-hydroxyethylmorpholine or 4-dimethylaminopyridine.

Preferably a water washing step is not employed during the manufacture of the lithographic printing plate.

Preferably after removing the protective layer and an unexposed area of the photosensitive layer using the processing solution, the lithographic printing plate precursor is dried by heating the plate precursor to have a surface temperature in the range of 25 to 80°C.

Preferably the binder polymer (D) is a (meth)acrylic resin or a polyvinyl butyral resin.

Preferably the protective layer contains one or more polyvinyl alcohols whose average degree of saponification is in the range of 70 to 93% by mol.

Preferably the pH of the processing solution is from 5 to 10.7.

The method of preparing a lithographic printing plate according to the invention is prevented from the odor generation and the occurrence of development scum, and can achieve a good balance between good developing property and preparation of a lithographic printing plate excellent in printing durability.

In the method of preparing a lithographic printing plate according to the invention, by incorporating the specific organic solvent into the processing solution, the solubility or dispersibility of the photosensitive layer containing the hexaarylbisimidazole compound and polymerizable compound having a hydrocarbon group having 6 or more carbon atoms in its molecule in the processing solution is increases, whereby the development scum hardly occurs in the development processing of the lithographic printing plate precursor. Moreover, by using the specific aliphatic organic solvent or aromatic organic solvent, the volatilization of the organic solvent is small so that the generation of odor can be prevented even when the lithographic printing plate precursor having the processing solution attached thereon is dried.

Furthermore, the method of preparing a lithographic printing plate according to the invention enables plate making by one bath processing and development by a small size developing machine and can reduce the running cost.

### Brief description of the drawing

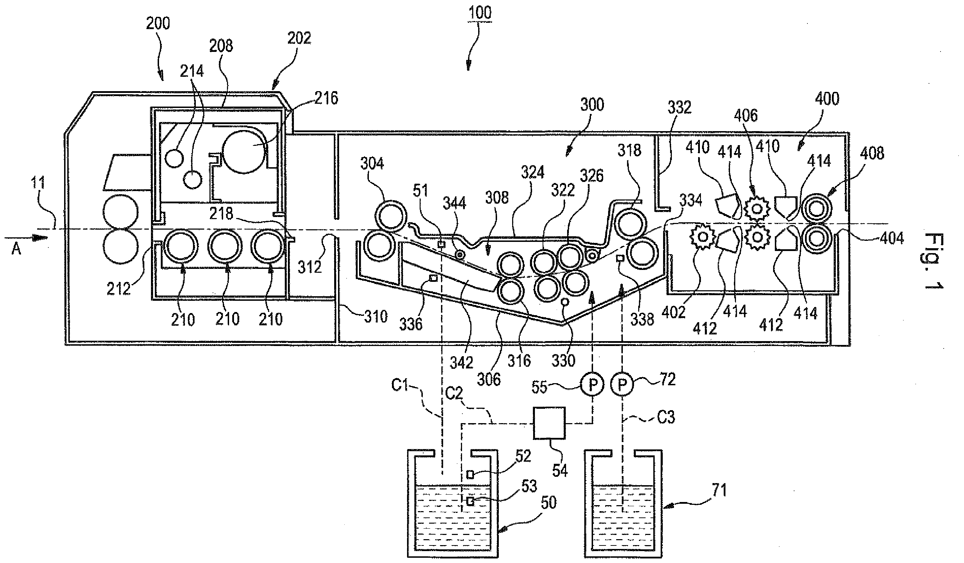

Fig. 1 is an illustration showing a structure of an automatic development processor.

### Description of reference numerals and signs

- 100:: Automatic development processing apparatus
- 200:: Pre-heating unit
- 300:: Developing unit
- 400:: Drying unit

### Detailed Description of the Invention

### [Lithographic printing plate precursor]

A photosensitive layer included in the lithographic printing plate precursor for use in the method of preparing a lithographic printing plate according to the invention contains (A) a hexaarylbisimidazole compound, (B) a polymerizable compound having a hydrocarbon group having 6 or more carbon atoms in its molecule, (C) a sensitizing dye and (D) a binder polymer. The photosensitive layer may further contain other components, if desired.

### (A) Hexaarylbisimidazole compound (polymerization initiator)

The polymerization initiator for use in the invention is a hexaarylbisimidazole compound.

The hexaarylbisimidazole compound includes, for example, lophine dimers described in JP-B-45-37377 (the term "JP-B" as used herein means an "examined Japanese patent publication") and JP-B-44-86516, specifically, 2,2'-bis(o-chlorophenyl)-4,4',5,5'-tetraphenylbisimidazole, 2,2'-bis(o-bromophenyl)-4,4',5,5'-tetraphenylbisimidazole, 2,2'-bis(o,p-dichlorophenyl)-4,4',5,5'-tetraphenylbisiznidazole, 2,2'-bis(n-chlorophenyl)-4,4',5,5'-tetra(m-methoxyphenyl)bisimidazole, 2,2'-bis(o,o'-dichlorophenyl)-4,4',5,5'-tetraphenylbisimidazole, 2,2'-bis(o-nitrophenyl)-4,4',5,5'-tetraphenylbisimidazole, 2,2'-bis(o-methylphenyl)-4,4',5,5'-tetraphenylbisimidazole and 2,2'-bis(o-trifluoromethylphenyl)-4,4' ,5,5' -tetraphenylbisimidazole.

The hexaarylbisimidazole compounds may be preferably used individually or in combination of two or more thereof.

The amount of the hexaarylbisimidazole compound used in the photosensitive layer is preferably from 0.01 to 20% by weight, more preferably from 0.1 to 15% by weight, still more preferably from 1.0 to 10% by weight, based on the total solid content of the photosensitive layer.

In the photosensitive layer according to the invention, other polymerization initiator may be used together with the hexaarylbisimidazole compound.

As the other polymerization initiator, polymerization initiators known to those skilled in the art can be used without limitation. Specifically, for example, a trihalomethyl compound, a carbonyl compound, an organic peroxide, an azo compound, an azide compound, a metallocene compound, an organic boron compound, a disulfone compound, an oxime ester compound, an onium salt compound and a iron arene complex are exemplified.

In addition, polymerization initiators described in JP-A-2007-171406, JP-A-2007-206216, JP-A-2007-206217, JP-A-2007-225701, JP-A-2007-225702, JP-A-2007-316582 and JP-A-2007-328243 are also exemplified.

The amount of the polymerization initiator used together with the hexaarylbisimidazole compound in the photosensitive layer according to the invention is preferably 50% by weight or less, more preferably 20% by weight or less, based on the weight of the hexaarylbisimidazole compound.

### (B) Polymerizable compound having hydrocarbon group having 6 or more carbon atoms in its molecule

The polymerizable compound for use in the photosensitive layer according to the invention is an addition-polymerizable compound having at least one ethylenically unsaturated double bond and a hydrocarbon group having 6 or more carbon atoms in its molecule, and it is selected from compounds having at least one, preferably two or more, terminal ethylenically unsaturated double bonds. The terminology "having a hydrocarbon group having 6 or more carbon atoms" means that the polymerizable compound has at least one monovalent or divalent hydrocarbon group having 6 or more carbon atoms in its molecule. Since the hydrocarbon group is hydrophobic and as a number of carbon atoms included increases, it becomes more hydrophobic and the solubility thereof in water more decreases and thus, it is hardly dissolved in the processing solution comprising water as the main component. The number of carbon atoms included in the hydrocarbon group is preferably from 6 to 12, more preferably from 6 to 10, and particularly preferably from 6 to 8.

By incorporating the organic solvent described below into the processing solution, the developing property is improved and further, scum resulting from the polymerizable compound is dispersed in the processing solution to increase time-lapse stability of the processing solution. The hydrocarbon group may be a monovalent hydrocarbon group when it is present at a terminal of the polymerizable compound and specifically includes, for example, an alkyl group or a phenyl group. The hydrocarbon group may be a divalent hydrocarbon group when used as a connecting group in the polymerizable compound and specifically includes, for example, an alkylene group or an arylene group. The polymerizable compound has a chemical form, for example, a monomer, a prepolymer, specifically, a dimer, a trimer or an oligomer, or a mixture thereof. Examples of the monomer include an unsaturated carboxylic acid (for example, acrylic acid, methacrylic acid, itaconic acid, crotonic acid, isocrotonic acid or maleic acid) and an ester or amide thereof. Preferably, an ester of an unsaturated carboxylic acid with a polyhydric alcohol compound and an amide of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer having a hydrocarbon group having 6 or more carbon atoms in its molecule, which is an ester of a polyhydric alcohol compound with an unsaturated carboxylic acid, include, as an acrylic acid ester, for example, hexanediol diacrylate or polyester acrylate oligomer. As a methacrylic acid ester, for example, bis[p-(3-methacryloxy-2-hydroxypropoxy)phenyl]dimethylmethane and bis[p-(methacryloxyethoxy)-phenyl]dimethylmethane are exemplified. Specific examples of the monomer, which is an amide of a polyvalent amine compound with an unsaturated carboxylic acid, include 1,6-hexamethylene bisacrylamide, 1,6-hexamethylene bismethacrylamide, xylylene bisacrylamide and xylylene bismethacrylamide.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups and a hydrocarbon group having 6 or more carbon atoms per molecule, described in JP-B-48-41708.

CH₂=C(R₄)COOCH₂CH(R₅)OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton and a hydrocarbon group having 6 or more carbon atoms described in JP-B-58-49860, JP-B-56-17654, JP-B-62-39417 and JP-B-62-39418 are preferably used.

The polymerizable compounds described in JP-T-2007-506125 are also preferred and polymerizable compounds having at least one urea group and/or tertiary amino group and a hydrocarbon group having 6 or more carbon atoms are particularly preferred. Specifically, the compounds set force below are exemplified.

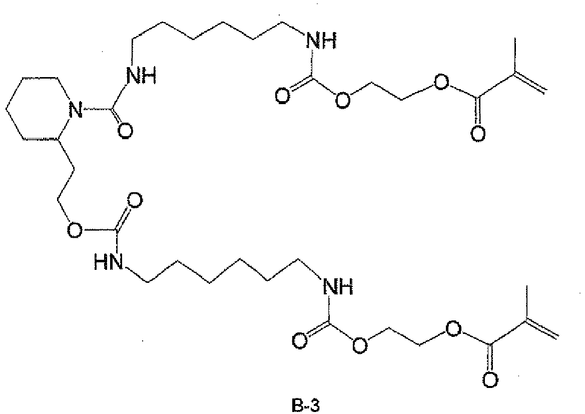

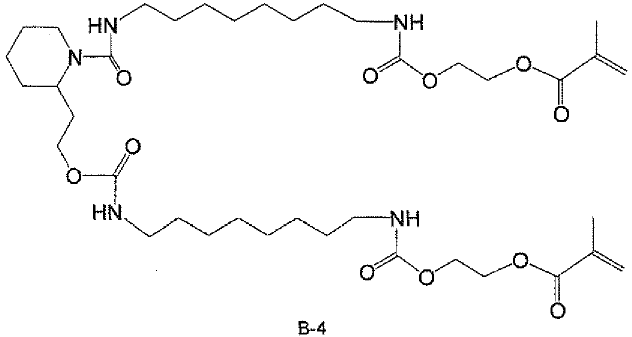

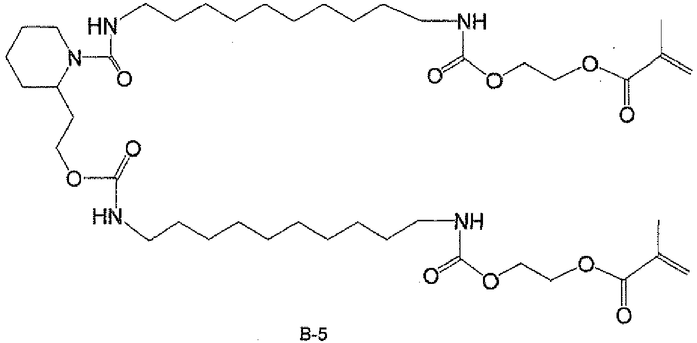

Details of the method of using the polymerizable compound, for example, selection of the structure, individual or combination use or an amount added, can be appropriately determined in accordance with the characteristic design of the final lithographic printing plate precursor. Further, the polymerizable compound may be used in combination with other monomer known in the field of art as described in Paragraph Nos. [0064] to [0088] of JP-T-2007-506125.

The polymerizable compound is used preferably in a range of 5 to 75% by weight, more preferably in a range of 25 to 70% by weight, particularly preferably in a range of 30 to 60% by weight, based on the total solid content of the photosensitive layer.

### (C) Sensitizing dye

The photosensitive layer according to the invention contains a sensitizing dye. The sensitizing dye can be used without particular limitation as far as it absorbs light at the image exposure to form the excited state and provides energy to the polymerization initiator described hereinbefore with electron transfer, energy transfer or heat generation thereby improving the polymerization initiation function. Particularly, a sensitizing dye having an absorption maximum in a wavelength range of 300 to 450 nm or 750 to 1,400 nm is preferably used.

Examples of the sensitizing dye having an absorption maximum in a wavelength range of 300 to 450 nm include merocyanine dyes, benzopyranes, coumarins, aromatic ketones and anthracenes.

Of the sensitizing dyes having an absorption maximum in a wavelength range of 300 to 450 nm, a dye represented by formula (IX) shown below is more preferred in view of high sensitivity. 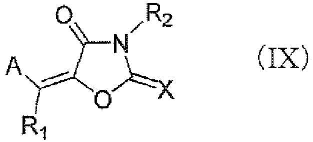 In formula (IX), A represents an aromatic cyclic group which may have a substituent or a heterocyclic group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

The formula (IX) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Now, A in formula (IX) is described below. A represents an aromatic cyclic group which may have a substituent or a heterocyclic group which may have a substituent.

Specific examples of the sensitizing dye preferably used include compounds described in Paragraph Nos. [0047] to [0053] of JP-A-2007-58170.

Further, a sensitizing dye represented by formula (V) or (VI) shown below can also be used.

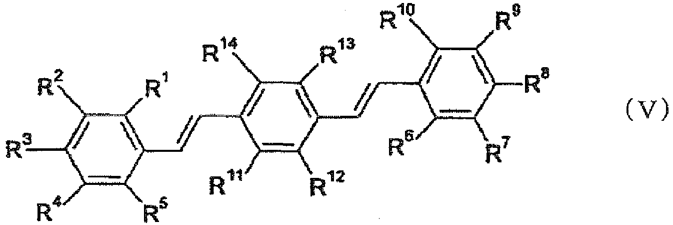

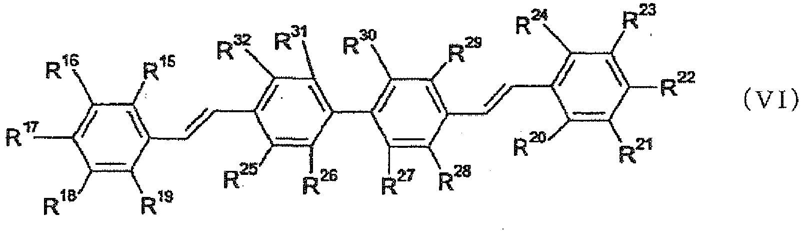

In formulae (V), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

In formula (VI), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

Specific examples of such sensitizing dye preferably used include compounds described in EP-A-1349006 and WO 2005/029187.

Further, sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

Next, the sensitizing dye having an absorption maximum in a wavelength range of 750 to 1,400 nm (hereinafter, also referred to as an "infrared absorbing agent") preferably used in the invention is described in detail below. The infrared absorbing agent used is preferably a dye or pigment

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

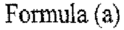

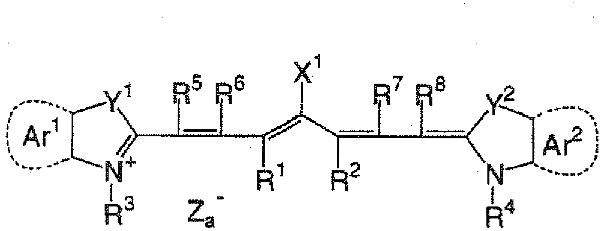

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic cyclic group containing a hetero atom (a nitrogen atom, a sulfur atom, an oxygen atom, a halogen atom or a selenium atom) or a hydrocarbon group having from 1 to 12 carbon atoms and containing a hetero atom. Xa⁻ has the same meaning as Za⁻ defined hereinafter. R^{a} represents a hydrogen atom or a substituent selected from an alkyl group, an aryl group, a substituted or unsubstituted amino group and a halogen atom.

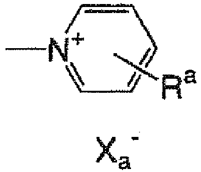

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms and it is also preferred that R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (a) has an anionic substituent in the structure thereof and the neutralization of charge is not needed. Preferable examples of the counter ion for Za⁻ include a halide ion, a perchlorate ion, a tetrafluoroborate ion, a hexafluorophosphate ion and a sulfonate ion in view of the preservation stability of a coating solution for photosensitive layer, and more preferable examples thereof include a perchlorate ion, a tetrafluoroborate ion, a hexafluorophosphate ion and a sulfonate ion in view of corrosion prevention of a support, and particularly preferable examples thereof include a perchlorate ion, a hexafluorophosphate ion and an arylsulfonate ion..

Specific examples of the cyanine dye represented by formula (a) which can be preferably used in the invention include those described in Paragraph Nos. [0017] to [0019] of JP-A-2001-133969.

Further, other particularly preferable examples of the dye include specific indolenine cyanine dyes described in JP-A-2002-278057.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

The amount of the sensitizing dye added is preferably in a range from 0.05 to 30 parts by weight, more preferably from 0.1 to 20 parts by weight, most preferably from 0.2 to 10 parts by weight, per 100 parts by weight of the total solid content of the photosensitive layer.

### (D) Binder polymer

The photosensitive layer according to the invention includes a binder polymer. As the binder polymer, a polymer capable of holding the components of photosensitive layer on a support and capable of being removed by a processing solution is used. The binder polymer used includes a (meth)acrylic resin, a polyurethane resin, a polyvinyl alcohol resin, a polyvinyl butyral resin, a polyvinyl formal resin, a polyamide resin, a polyester resin and an epoxy resin. In particular, a (meth)acrylic resin, a polyurethane resin or a polyvinyl butyral resin is preferably used.

The term "(meth)acrylic resin" as used herein means a copolymer containing as a polymerization component, (meth)acrylic acid or a (meth)acrylic acid derivative, for example, a (meth)acrylate (including, for example, an alkyl ester, an aryl ester and an allyl ester), (meth)acrylamide or a (meth)acrylamide derivative.

The term "polyurethane resin" as used herein means a polymer formed by a condensation reaction of a compound having two or more isocyanate groups and a compound having two or more hydroxy groups.

The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and also includes a polymer wherein an acid group or the like is introduced, for example, by a method of reacting the remaining hydroxy group with a compound having the acid group or the like.

One preferable example of the binder polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferred. As the repeating unit, a repeating unit derived from (meth)acrylic acid or a repeating unit represented by formula (BI) shown below is preferably used.

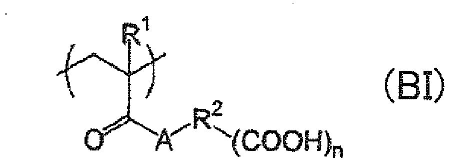

In formula (BI), R¹ represents a hydrogen atom or a methyl group, R₂ represents a single bond or an n+1 valent connecting group, A represents an oxygen atom or -NR³-, wherein R³ represents a hydrogen atom or a monovalent hydrocarbon group having from 1 to 10 carbon atoms, and n represents an integer of 1 to 5.

The connecting group represented by R² in formula (BI) is constructed from a carbon atom, a hydrogen atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group. The connecting group may have a structure wherein a plurality of such divalent groups is connected to each other via an amido bond or an ester bond. R² is preferably a single bond, an alkylene group or a substituted alkylene group, more preferably a single bond, an alkylene group having from 1 to 5 carbon atoms or a substituted alkylene group having from 1 to 5 carbon atoms, and particularly preferably a single bond, an alkylene group having from 1 to 3 carbon atoms or a substituted alkylene group having from 1 to 3 carbon atoms.

Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, more preferably a hydrogen atom or a hydrocarbon group having from 1 to 3 carbon atoms, and particularly preferably a hydrogen atom or a methyl group.

n is preferably from 1 to 3, more preferably 1 or 2, and particularly preferably 1.

A ratio of the copolymerization component having a carboxylic acid group in the total copolymerization components of the binder polymer is preferably from 1 to 70% in view of developing property. Considering good compatibility between the developing property and printing durability, it is more preferably from 1 to 50%, and particularly preferably from 1 to 30%.

Further, a polyvinyl butyral resin having an acid group introduced, for example, a resin represented by formula (BII) shown below is also preferably used.

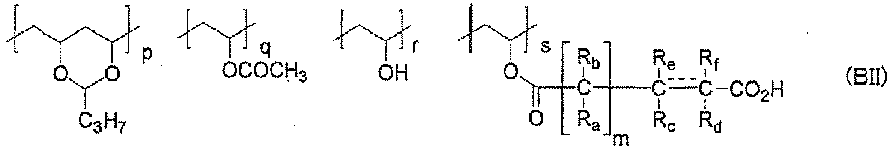

In formula (BII), a ratio of each repeating unit p/q/r/s is preferably in a range from 50 to 78% by mole/from 1 to 5% by mol/from 5 to 28% by mol/from 5 to 20% by mol. Rₐ and R_{b} each independently represents a hydrogen atom, a monovalent substituent which may have a substituent, R_{c}, R_{d}, Rₑ and R_{f} each independently represents a hydrogen atom, a monovalent substituent which may have a substituent or a single bond, and m represents 0 or 1. Preferable examples of the monovalent substituent represented by any one of Rₐ, R_{b}, R_{c}, R_{d}, Rₑ and R_{f} include an alkyl group which may have a substituent, a halogen atom and an aryl group which may have a substituent. More preferable examples thereof include a straight-chain alkyl group, for example, a methyl group, an ethyl group or a propyl group, an alkyl group substituted with a carboxylic acid, a halogen atom, a phenyl group and a phenyl group substituted with a carboxylic acid. R_{c} and R_{d} or Rₑ and R_{f} may form a ring structure. The bond between the carbon atom to which R_{c} and Rₑ connect and the carbon atom to which R_{d} and R_{f} connect is a single bond, a double bond or an aromatic double bond and in the case of the double bond or aromatic double bond, R_{c} and R_{d}, Rₑ and R_{f}, R_{c} and R_{f} or Rₑ and R_{d} are connected with each other to form a single bond.

Preferable specific examples of the repeating unit having a carboxylic acid group are set forth below.

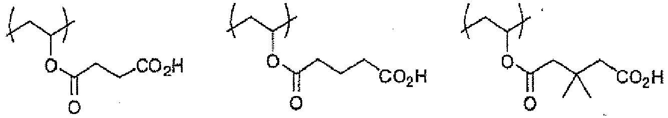

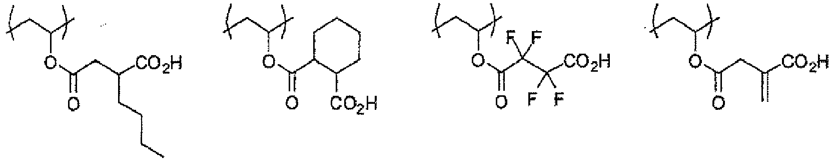

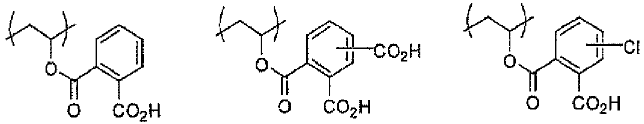

Moreover, the acid group of a polymer having an acid group which is a preferable example of the binder polymer according to the invention may be neutralized with a basic compound. Particularly, it is preferred to be neutralized with a compound having a basic nitrogen atom, for example, an amino group, an amidine group or a guanidine group. It is also preferred that the compound having a basic nitrogen atom has an ethylenically unsaturated group. Specific examples of the compound include compounds described in WO 2007/057442.

It is preferred that the binder polymer for use in the invention further contains a crosslinkable group. The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is preferred. The ethylenically unsaturated bond group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause addition polymerization between the polymers directly or through a polymerization chain of the polymerizable compound and as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, most preferably from 0.1 to 2.0 mmol, per g of the binder polymer.

The binder polymer for use in the invention may contain a polymerization unit of alkyl (meth)acrylate or aralkyl (meth)acrylate besides the polymerization unit having an acid group and the polymerization unit having a crosslinkable group. The alkyl group in the alkyl (meth)acrylate is preferably an alkyl group having from 1 to 5 carbon atoms and more preferably a methyl group. The aralkyl (meth)acrylate includes, for example, benzyl (meth)acrylate.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof.

The content of the binder polymer is preferably from 5 to 75% by weight, more preferably from 10 to 70% by weight, still more preferably from 10 to 60% by weight, based on the total solid content of the photosensitive layer from the standpoint of good strength of the image area and good image-forming property.

The total content of the polymerizable compound and the binder polymer is preferably 80% by weight or less based on the total solid content of the photosensitive layer. When it exceeds 80% by weight, decrease in the sensitivity and deterioration in the developing property may be caused sometimes. The total content is more preferably from 35 to 75% by weight.

According to the invention, by controlling a ratio of the polymerizable compound to the binder polymer contained in the photosensitive layer of the lithographic printing plate precursor, the permeability of developer into the photosensitive layer more increases and the developing property is further improved. Specifically, a weight ration of polymerizable compound/binder polymer in the photosensitive layer is preferably 1.2 or more, more preferably from 1.25 to 4.5, and particularly preferably from 2 to 4.

### <Other components for photosensitive layer>

The photosensitive layer preferably further contains a chain transfer agent. As the chain transfer agent, for example, compounds having SH, PH, SiH or GeH in their molecules are used. The compound donates hydrogen to a low active radical species to generate a radical or is oxidized and deprotonized to generate a radical.

In particular, a thiol compound (for example, a 2-mercaptobenzimidazole, a 2-mercaptobenzothiazole, a 2-mercaptobenzoxazole, a 3-mercaptotriazole or a 5-mercaptotetrazole) is preferably used as the chain transfer agent in the photosensitive layer according to the invention.

Into the photosensitive layer according to the invention, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer for increasing sensitivity and a plasticizer for improving plasticity. As the additives, known compounds are used and, for example, compounds described in Paragraph Nos. [0161] to [0215] of JP-A-2007-206217 are used.

### <Formation of photosensitive layer>

The photosensitive layer according to the invention is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer on the support after the coating and drying is preferably from 0.3 to 3.0 g/m². Various methods can be used for the coating. Examples of the method include bar coater coating, spin coating, spray coating, curtain coating, dip coating, air knife coating, blade coating and roll coating.

### <Protective layer>

In the lithographic printing plate precursor according to the invention, a protective layer (oxygen-blocking layer) is provided on the photosensitive layer in order to prevent diffusion and penetration of oxygen which inhibits the polymerization reaction at the time of exposure. As a material used in the protective layer, for example, a water-soluble polymer compound relatively excellent in crystallizability is preferably used. Specifically, when polyvinyl alcohol is used as a main component, the best results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and solubility in water. Also, polyvinyl alcohol may partly have other copolymer component. Polyvinyl alcohol is obtained by hydrolysis of polyvinyl acetate. As specific examples of the polyvinyl alcohol, those having a hydrolysis degree of 71 to 100% by mole and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferred embodiment, the content of polyvinyl alcohol in the protective layer is from 20 to 95% by weight, and more preferably from 30 to 90% by weight.

Also, known modified polyvinyl alcohol can be preferably used. Particularly, an acid-modified polyvinyl alcohol having a carboxylic acid group or a sulfonic acid group is preferably used. As a component used as a mixture with polyvinyl alcohol, polyvinyl pyrrolidone or a modified product thereof is preferred from the viewpoint of the oxygen-blocking property and removability by development. The content thereof is ordinarily from 3.5 to 80% by weight, preferably from 10 to 60% by weight, more preferably from 15 to 30% by weight, in the protective layer.

It is preferred that the protective layer contains at least one kind of polyvinyl alcohols and that an average saponification degree of the total polyvinyl alcohols contained is in a range of 70 to 93% by mole.

As other component of the protective layer, glycerin, dipropylene glycol or the like can be added in an amount of several % by weight of the water-soluble polymer compound to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount of several % by weight of the water-soluble polymer compound.

Further, it is also preferred to incorporate an inorganic stratiform compound described in Paragraph Nos. [0018] to [0024] of JP-A-2006-106700 into the protective layer of the lithographic printing plate precursor according to the invention for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful.

The coating amount of the protective layer is preferably in a range of 0.05 to 10 g/m² in terms of the coating amount after drying. When the protective layer contains the inorganic stratiform compound, it is more preferably in a range of 0.1 to 5 g/m², and when the protective layer does not contain the inorganic stratiform compound, it is more preferably in a range of 0.5 to 5 g/m².

### [Support]

A support for use in the lithographic printing plate precursor according to the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of 3P-2007-206217 are preferably used.

The center line average roughness of the support is preferably from 0.10 to 1.2 µm. In the range described above, good adhesion property to the photosensitive layer, good printing durability and good resistance to stain are achieved.

The color density of the support is preferably from 0.15 to 0.65 in terms of the reflection density value. In the range described above, good image-forming property by preventing halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

### <Hydrophilizing treatment of support and undercoat layer>

In the lithographic printing plate precursor according to the invention, in order to increase hydrophilicity of the non-image area and to prevent printing stain, it is preferred to conduct hydrophilizing treatment of the surface of support or to provide an undercoat layer between the support and the photosensitive layer.

The hydrophilizing treatment of the surface of support includes an alkali metal silicate treatment wherein the support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

As the undercoat layer, an undercoat layer containing a compound having an acid group, for example, a phosphonic acid group, a phosphoric acid group or a sulfonic acid group is preferably used. It is preferred that the compound further has a polymerizable group in order to increase the adhesion property to the photosensitive layer. Also, a compound further having a hydrophilicity-imparting group, for example, an ethylene oxide group is exemplified as a preferable compound.

These compounds may be low molecular weight compounds or polymer compounds. For example, a silane coupling agent having an addition-polymerizable ethylenic double bond reactive group described in JP-A-10-282679 and a phosphorus-containing compound having an ethylenic double bond reactive group described in JP-A-2-304441 are preferably exemplified.

As the most preferable undercoat layer, an undercoat layer containing a low molecular weight compound or polymer compound having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263 is exemplified.

A coating amount (solid content) of the undercoat layer is preferably from 0.1 to 100 mg/m², and more preferably from 1 to 30 mg/m².

### <Backcoat layer>

A backcoat layer can be provided on the back surface of the support, if desired, after applying the surface treatment to the support or forming the undercoat layer on the support.

The backcoat layer preferably includes, for example, a coating layer comprising an organic polymer compound described in JP-A-5-45885 and a coating layer comprising a metal oxide obtained by hydrolysis and polycondensation of an organic metal compound or inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting materials are inexpensive and easily available.

### [Method of preparing lithographic printing plate]

According to the present invention, a method of developing with a processing solution having pH of 2 to 11 is used.

Specifically, the lithographic printing plate precursor according to the invention is subjected to the development processing with the processing solution having pH of 2 to 11 to remove together the protective layer and the unexposed area of the photosensitive layer so that the resulting lithographic printing plate can be immediately mounted on a printing machine to perform printing. According to the invention, the processing solution preferably contains a surfactant and/or a water-soluble polymer compound and the development and gum solution treatment are preferably conducted at the same time. Therefore, a post-water washing step is not necessary, and after conducting the development and gum solution treatment with one solution, a drying step is preferably performed. Moreover, a pre-water washing step is also not necessary and removal of the protective layer is also preferably conducted simultaneously with the development and gum solution treatment. It is also preferred that after the development and gum treatment, the excess processing solution is removed using a squeeze roller, followed by conducting drying. The development of the lithographic printing plate precursor according to the invention is performed in a conventional manner at temperature ordinarily from 0 to 60°C, preferably from about 15 to about 40°C, using, for example, a method wherein the exposed lithographic printing plate precursor is immersed in the processing solution and rubbed with a brush or a method wherein the processing solution is sprayed to the exposed lithographic printing plate precursor and the exposed lithographic printing plate precursor is rubbed with a brush. The development processing by an automatic development processor is advantageous in view of being free from the measures against development scum resulting from the protective layer and/or photosensitive layer encountered in case of the on-press development.

Specifically, it is preferred that a step of preparing a lithographic printing plate according to the invention comprises an exposing step of exposing the lithographic printing plate precursor with laser and a step of removing the protective layer and an unexposed area of the photosensitive layer of the exposed lithographic printing palate precursor using the processing solution, and dose not contain a water washing step. Further, it is preferred that after the step of preparing a lithographic printing plate, a water washing step is not conducted before a printing step. The printing step means a step starting with mounting of the lithographic printing plate prepared on a printing machine.

It is also preferred that after removing the protective layer and the unexposed area of the photosensitive layer using the processing solution, the lithographic printing plate precursor is dried by heating at a plate surface temperature in a range of 25 to 80°C.

The processing solution for use in the invention is an aqueous solution having pH of 2 to 11. It is preferably an aqueous solution containing water as a main component (containing 60% by weight or more of water). In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the processing solution is more preferably from 5 to 10.7, still more preferably from 6 to 10.5, and particularly preferably from 6.9 to 10.3.

The anionic surfactant for use in the processing solution according to the invention is not particularly limited and includes fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and allcyldiphenylether (di)sulfonic acid salts are particularly preferably used.

The cationic surfactant for use in the processing solution according to the invention is not particularly limited and conventionally known cationic surfactants can be used. Examples of the cationic surfactant include alkylamine salts, quaternary ammonium salts, polyoxyethylene alkyl amine salts and polyethylene polyamine derivatives.

The nonionic surfactant for use in the processing solution according to the invention is not particularly limited and includes polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol or sorbitan, fatty acid esters of sucrose, alkyl ethers of polyhydric alcohols and fatty acid amides of alkanolamines. Of the compounds, those having an aromatic ring and an ethylene oxide chain are preferred, and an alkyl-substituted or unsubstituted phenol ethylene oxide adduct and an alkyl-substituted or unsubstituted naphthol ethylene oxide adduct are more preferred.

The amphoteric surfactant for use in the processing solution according to the invention is not particularly limited and includes an amine oxide type, for example, alkyldimethylamine oxide, a betaine type, for example, alkyl betaine and an amino acid type, for example, sodium salt of alkylamino fatty acid. In Particular, an alkyldimethylamine oxide which may have a substituent, an alkyl carboxy betaine which may have a substituent and an alkyl sulfo betaine which may have a substituent are preferably used. Specific examples of the compound used include compounds described, for example, in Paragraph Nos. [0255] to [0278] of JP-A-2008-203359 and Paragraph Nos. [0028] to [0052] of JP-A-2008-276166.

Two or more kinds of the surfactants may be used in combination. The content of the surfactant in the processing solution is preferably from 0.01 to 20% by weight, and more preferably from 0.1 to 10% by weight.

The water-soluble polymer compound for use in the processing solution according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range of 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more kinds of the water-soluble polymer compounds may be used in combination. The content of the water-soluble polymer compound in the processing solution is preferably from 0.1 to 20% by weight, and more preferably from 0.5 to 10% by weight.

The processing solution for use in the invention may further contain a pH buffer agent.

As the pH buffer agent used in the invention, a pH buffer agent exhibiting a pH buffer function at pH of 2 to 11 is used without particular restriction. In the invention, a weak alkaline buffer agent is preferably used and includes, for example, (a) a combination of a carbonate ion and a hydrogen carbonate ion, (b) a borate ion, (c) a combination of a water-soluble amine compound and an ion of the water-soluble amine compound, and combinations thereof. Specifically, for example, (a) a combination of a carbonate ion and a hydrogen carbonate ion, (b) a borate ion, or (c) a combination of a water-soluble organic amine compound and an ion of the water-soluble amine compound exhibits a pH buffer function in the processing solution to prevent fluctuation of the pH even when the processing solution is used for a long period of time. As a result, for example, the deterioration of developing property resulting from the fluctuation of pH and the occurrence of development scum are restrained. The combination of a carbonate ion and a hydrogen carbonate ion is particularly preferred.

In order for a carbonate ion and a hydrogen carbonate ion to be present in the processing solution, a carbonate and a hydrogen carbonate may be added to the processing solution or a carbonate ion and a hydrogen carbonate ion may be generated by adding a carbonate or a hydrogen carbonate to the processing solution and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually or in combination of two or more thereof.

When the combination (a) of a carbonate ion and a hydrogen carbonate ion is adopted as the pH buffer agent, the total amount of the carbonate ion and hydrogen carbonate ion is preferably from 0.05 to 5 mol/l, more preferably from 0.1 to 2 mol/l, particularly preferably from 0.2 to 1 mol/l, in the processing solution.

The water-soluble organic amine compounds are not particularly restricted and a water-soluble organic amine compound selected from monoethanolamine, diethanolamine, triethanolamine, N-hydroxyethylmorpholine and 4-dimethylaminopyridine is preferred. The water-soluble organic amine compounds may be used individually or in combination of two or more thereof. Moreover, as a counter anion of the ion of the water-soluble organic amine compound, phosphate ion, phosphite ion, sulfate ion, halide ion, carboxylate ion and the like can be used. It is more preferably phosphate ion and/or phosphite ion from the standpoint of pH stability of the processing solution.

When (c) a water-soluble organic amine compound and an ion of the water-soluble amine compound is adopted as the pH buffer agent, the total amount of the water-soluble organic amine compound and the ion thereof is preferably from 0.005 to 5 mol/l, more preferably from 0.01 to 2 mol/l, particularly preferably from 0.01 to 1 mol/l, in the processing solution.

The processing solution contains an organic solvent in order to improve solubility or dispersibility of the polymerizable compound which has very poor solubility or dispersibility in the processing solution of an acidic to weak alkaline range. The organic solvent includes an alcohol having a straight-chain, branched or cyclic aliphatic hydrocarbon group having from 9 to 12 carbon atoms represented by formula (I) shown below from the standpoint of preventing generation of odor due to the volatilization thereof.

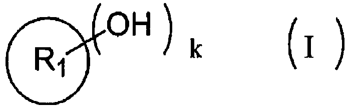

In formulae (I), R₁ represents a k-valent straight-chain, branched or cyclic aliphatic hydrocarbon group having from 9 to 12 carbon atoms, and k represents an integer of 1 or more.

In formula (I), R₁ is preferably an alkyl group or alkylene group.

k is preferably 1 or 2.

Examples of the compound represented by formula (I) include 1-nonanol, 1-decanol, 1-undecanol, 1-dodecanol and 3,5,5,-trimethyl-1-hexanol.

The content of the compound (E) represented by formula (I) in the processing solution is preferably from 0.01 to 10% by weight, more preferably from 0.01 to 5% by weight, still more preferably from 0.01 to 0.05% by weight, in terms of the total amount thereof.

The processing solution according to the invention further contains an aromatic organic solvent in order to improve solubility or dispersibility of the polymerization initiator which has very poor solubility or dispersibility in the processing solution of an acidic to weak alkaline range. The aromatic organic solvent includes (F) a compound represented by formula (III) shown below from the standpoint of preventing generation of odor due to the volatilization thereof.

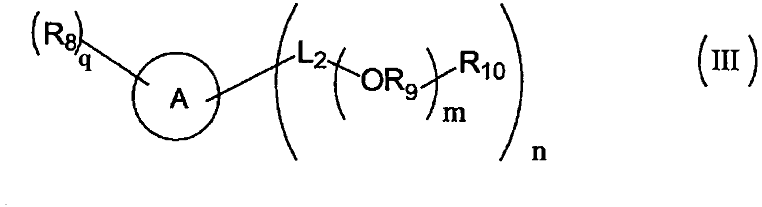

In formulae (III), A represents an aromatic ring, R₈ represents an alkyl group having from 1 to 3 carbon atoms, L₂ represents a single bond or an alkylene group having from 1 to 4 carbon atoms, R₉ represents an alkylene group having from 1 to 4 carbon atoms, R₁₀ represents a hydroxy group, an alkoxy group having from 1 to 4 carbon atoms, a phenoxy group or a naphthoxy group, m represents an integer of 0 to 4, q represents an integer of 0 to 5, and n represents an integer of 1 to 8, provided that 1 and n satisfy 1 ≤ q + n≤8.

In formula (III), A is preferably a benzene ring or a naphthalene ring.

R₈ is preferably a methyl group.

L₂ is preferably a single bond or an alkylene group having 1 or 2 carbon atoms.

R₉ is preferably an alkylene group having from 1 to 3 carbon atoms.

R₁₀ is preferably a hydroxy group.

q is preferably 0 or 1.

m is preferably from 2 to 4.

n is preferably 4 or less, and more preferably 2 or less.

Also, it is more preferred that in formula (III), R₉ is an alkylene group having 1 or 2 carbon atoms or that m is an integer of 2 to 4.

Examples of the compound represented by formula (III) preferably include an aromatic organic solvent, for example, compounds represented by the structural formulae shown below.

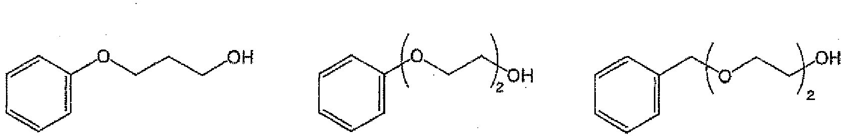

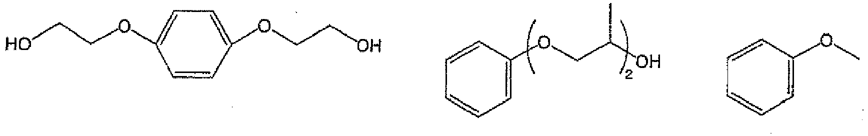

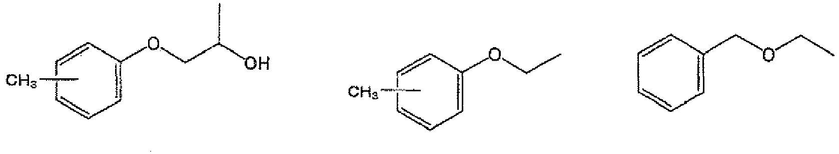

The content of the compound (F) represented by formula (III) in the processing solution is preferably from 0.01 to 10% by weight, more preferably from 0.01 to 5% by weight, and still more preferably from 0.01 to 0.05% by weight.

In the processing solution, a mixing ratio (by weight) of the compound (E) to the compound (F) is preferably from 1/9 to 9/1, more preferably from 2/8 to 8/2, particularly preferably from 3/7 to 7/3, in terms of ratio of the compound (E)/the compound (F).

When the organic solvent (compound (E) and compound (F)) has a low solubility in water, it may be employed by being solubilized in water using a surfactant or the like. As the surfactant, a nonionic surfactant is preferred.

The total concentration of the organic solvent in the processing solution is desirably less than 40% by weight in view of safety and inflammability, furthermore, is desirably less than 20% by weight in view of smell of organic solvent.

The processing solution according to the invention may contain a preservative, a chelating agent, a defoaming agent, an organic acid, an inorganic acid, an inorganic salt or the like in addition to the components described above. Specifically, compounds described in Paragraph Nos. [0266] to [0270] of JP-A-2007-206217 are preferably used.

The processing solution described above can be used as a developer or a development replenisher for an exposed lithographic printing plate precursor and is preferably applied to an automatic processor described below. In the case of performing development using an automatic processor, the developer becomes fatigued in accordance with the processing amount, and hence the processing ability may be restored using a replenisher or a fresh developer.

The development processing with the processing solution having pH of 2 to 11 according to the invention is preferably performed by an automatic processor equipped with a supplying means for the processing solution and a rubbing member. An automatic processor using a rotating brush roll as the rubbing member is particularly preferred.

Further, the automatic processor is preferably provided with a means for removing the excess processing solution, for example, a squeeze roller, or a drying means, for example, a hot air apparatus, subsequently to the development processing means. The plate surface temperature of the lithographic printing plate precursor at the time of drying is preferably from 25 to 80°C, more preferably from 40 to 80°C, still more preferably from 50 to 80°C, and particularly preferably from 60 to 80°C. When the plate surface temperature is too low, the lithographic printing plate precursor is not sufficiently dried to cause a problem of stickiness or the like. When the plate surface temperature is too high, the volatile components volatilize to cause a problem of odor generation. The plate surface temperature means temperature in a position corresponding to the center on the processed side of the lithographic printing plate precursor immediately after the drying step. The plate surface temperature is temperature determined by noncontact measurement using a radiation thermometer.

As the automatic development processor, for example, an automatic development processing apparatus having a structure as shown in Fig.1 is exemplified.

An automatic development processing apparatus 100 shown in Fig.1 comprises a chamber the outer shape of which is formed by a machine casing 202 and has a pre-heating unit 200, a developing unit 300 and a drying unit 400 continuously formed along a transporting direction (arrow A) of a lithographic printing plate precursor 11.

The pre-heating unit 200 comprises a heating chamber 208 having a transporting inlet 212 and a transporting outlet 218 and a skewer roller 210 and a heater 214 and a circulating fan 216 are arranged in the inside thereof

The developing unit 300 is separated from the pre-heating unit 200 by an outer panel 310 and an insertion slot 312 of slit type is formed in the outer panel 310.

In the developing unit 300, a processing tank 306 having a developing tank 308 filled with a developer and a pair of insertion rollers 304 for guiding the lithographic printing plate precursor 11 into the processing tank 306 are disposed. A shielding cover 324 is located above the developing tank 308.

In the developing tank 308, a guide roller 344 and a guide member 342, a pair of submerged rollers 316, a pair of brush rollers 322, a pair of brush rollers 326 and a pair of carrying-out rollers 318 are provided in order from the upstream side of the transporting direction of lithographic printing plate precursor. The lithographic printing plate precursor 11 transported into the developing tank 308 is immersed in the developer and the non-image area is removed by passing between the pairs of rotating brush rollers 322 and 326.

A spray pipe 330 is provided under the pairs of brush rollers 322 and 326. The spray pipe 330 is connected to a pump (not shown) and the developer in the developing tank 308 sucked by the pump is ejected from the spray pipe 330 in the developing tank 308.

On a sidewall of the developing tank 308, an overflow aperture 51 is provided to form a top edge of a first circulation pipeline C1. The excess developer flows in the overflow aperture 51, passes through the first circulation pipeline C1 and is discharged in an external tank 50 provided outside the developing unit 300.

To the external tank 50 is connected a second circulation pipeline C2 and a filter unit 54 and a developer supply pump 55 are located in the second circulation pipeline C2. The developer is supplied from external tank 50 to the developing tank 308 by the developer supply pump 55. In the external tank 50, a level meter 52 and a level meter 53 are provided.

The developing tank 308 is also connected to a water tank 71 for replenishment through a third circulation pipeline C3. A water-replenishing pump 72 is located in the third circulation pipeline C3 and water pooled in the water tank 71 for replenishment is supplied to the developing bath 308 by the water-replenishing pump 72.

A liquid temperature sensor 336 is provided on the upstream side of the pair of submerged rollers 316. A liquid level meter 338 is provided on the upstream side of the pair of carrying-out rollers 318.

In a partition board 332 placed between the developing unit 300 and the drying unit 400, a pass-through slot 334 of slit type is formed. Also, a shutter (not shown) is provided along a passage between the developing unit 300 and the drying unit 400 and the passage is closed by the shutter when the lithographic printing plate 11 precursor does not pass through the passage.

In the drying unit 400, a support roller 402, ducts 410 and 412, a pair of transport rollers 406, ducts 410 and 412 and a pair of transport rollers 408 are disposed in this order. A slit hole 414 is provided at the top of each of the ducts 410 and 412. In the drying unit 400, a drying means (not shown), for example, a hot air supplying means or a heat generating means, is also provided. The drying unit 400 has a discharge slot 404 and the resulting lithographic printing plate dried by the drying means is discharged through the discharge slot 404.

Further, in the method of preparing a lithographic printing plate using the lithographic printing plate precursor according to the invention, the entire surface of the lithographic printing plate precursor may be heated before the exposure, during the exposure or between the exposure and the development, if desired. By the heating, the image-forming reaction in the photosensitive layer is accelerated and advantages, for example, improvement in the sensitivity and printing durability and stabilization of the sensitivity may be achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions. Ordinarily, the heat treatment is carried out in a temperature range of 100 to 500°C. When the temperature is too low, the sufficient effect of strengthening the image may not be obtained, whereas when it is excessively high, problems of deterioration of the support and thermal decomposition of the image area may occur sometimes.

In advance of the above-described development processing, the lithographic printing plate precursor is imagewise exposed with laser through a transparent original having a line image, a halftone dot image or the like, or imagewise exposed, for example, by scanning of laser beam based on digital data.

The wavelength of the exposure light source is preferably from 300 to 450 nm or from 750 to 1,400 nm. In case of exposing with light of 300 to 450 nm, the lithographic printing plate precursor having a photosensitive layer containing a sensitizing dye having an absorption maximum in the wavelength range is used. In case of exposing with light of 750 to 1,400 nm, the lithographic printing plate precursor containing an infrared absorbing agent which is a sensitizing dye having an absorption maximum in the wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

### [Example]

The present invention will be described in more detail with reference to the following examples, but the invention should not be construed as being limited thereto. Examples 1 to 55 and Comparative Examples I to 17

### [Preparation of Lithographic printing plate precursor (1)]

### <Preparation of Support>

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The degreased aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate thus-treated was subjected to an anodizing treatment under condition of current density of 10 A/dm² and voltage of 15 V in an aqueous 15% by weight sulfuric acid solution at 25°C for one minute and then subjected to a hydrophilization treatment using an aqueous 1% by weight polyvinylphosphonic acid solution at 75°C to prepare a support. The surface roughness of the support was measured and found to be 0.44 µm (Ra indication according to JIS B0601).

### <Formation of Photosensitive layer 1>

Coating solution (1) for photosensitive layer having the composition shown below was coated on the support using a bar and dried in an oven at 90°C for 60 seconds to form Photosensitive layer 1 having a dry coating amount of 1.3 g/m².

### <Coating solution (1) for photosensitive layer>

| | |
|---|---|
| Binder Polymer (1) shown below (weight average molecular weight: 50,000) | 0.04 g |
| Binder Polymer (2) shown below (weight average molecular weight: 80,000) | 0.30 g |
| Polymerizable Compound (1) shown below | 0.17 g |
| (PLEX 6661-O, produced by Degussa Japan Co. Ltd.) | |
| Polymerizable Compound B-3 described hereinbefore | 0.51 g |
| Sensitizing Dye (1) shown below | 0.03 g |
| Sensitizing Dye (2) shown below | 0.015 g |
| Sensitizing Dye (3) shown below | 0.015 g |
| Polymerization Initiator (1) shown below | 0.13 g |
| Chain Transfer Agent | 0.01 g |
| Mereaptobenzothiazole | |
| Dispersion of ε-phthalocyanine pigment | 0.40 g |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| Thermal polymerization inhibitor | 0.01 g |
| N-nitrosophenylhydroxylamine aluminum salt | |
| Fluorine-Based Surfactant (1) shown below (weight average molecular weight: 10,000) | 0.001 g |
| 1-Methoxy-2-propanol | 3.5 g |
| Methyl ethyl ketone | 8.0 g |

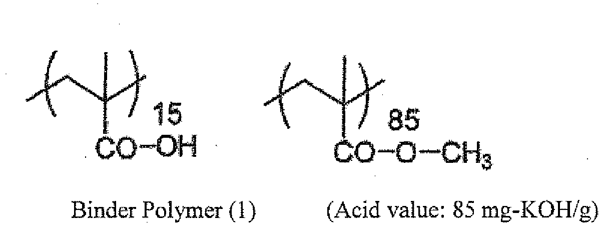

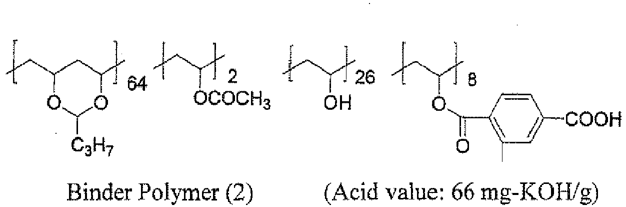

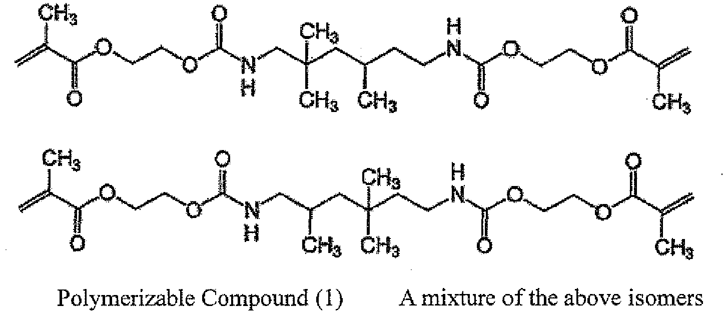

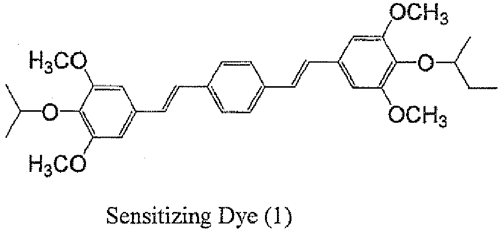

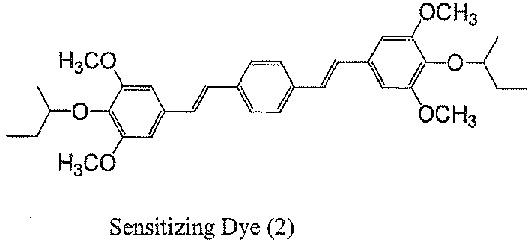

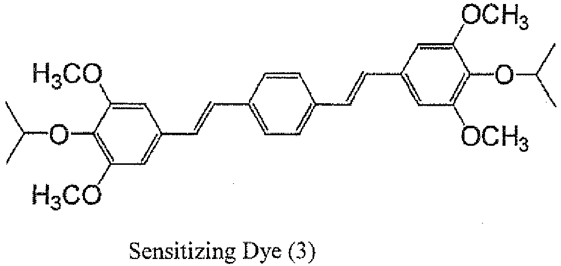

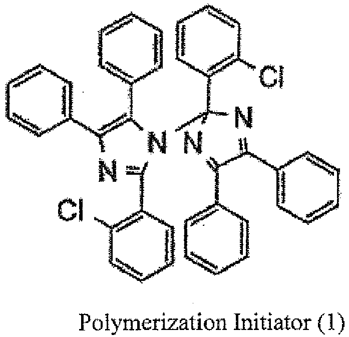

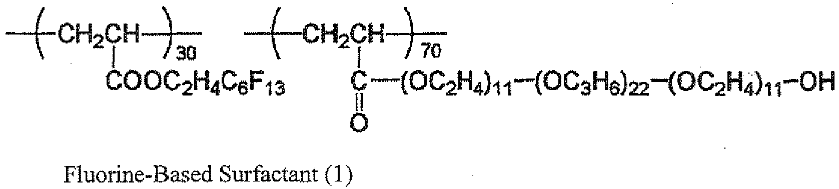

### <Formation of Protective layer 1>

Coating solution (1) for protective layer having the composition shown below was coated on Photosensitive layer 1 using a bar so as to have a dry coating amount of 1.2 g/m² and dried at 125°C for 70 seconds to form Protective layer 1, thereby preparing Lithographic printing plate precursor (1).

### <Coating solution (1) for protective layer>

| | |
|---|---|
| PVA-205 [partially hydrolyzed polyvinyl alcohol, produced by Kuraray Co., Ltd. (saponification degree: 86.5 to 89.5% by mole; viscosity: 4.6 to 5.4 mPa·s in a 4% by weight aqueous solution at 20°C)] | 0.658 g |
| PVA-105 [fully hydrolyzed polyvinyl alcohol, produced by | 0.142 g |
| Kuraray Co., Ltd. (saponification degree: 98.0 to 99.0% by mole; viscosity: 5.2 to 6.0 mPa·s in a 4% by weight aqueous solution at 20°C)] | |
| Vinyl pyrrolidone/vinyl acetate (1/1) copolymer (weight average molecular weight: 70,000) | 0.001 g |
| Surfactant (EMALEX 710, produced by Nihon Emulsion Co., Ltd.) | 0.002 g |
| Water | 13 g |

### [Preparation of Lithographic printing plate precursor (2) for comparison]

Lithographic printing plate precursor (2) for comparison was prepared in the same manner as in Lithographic printing plate precursor (1) expect for changing Polymerizable compound B-3 in Photosensitive layer (1) to Polymerizable compound B-1 shown below.

### [Preparation of Lithographic printing plate precursor (3) for comparison]

Lithographic printing plate precursor (3) for comparison was prepared in the same manner as in Lithographic printing plate precursor (1) expect for changing Polymerizable compound B-3 in Photosensitive layer (1) to Polymerizable compound B-2 shown below.

### [Preparation of Lithographic printing plate precursor (4)]

Lithographic printing plate precursor (4) was prepared in the same manner as in Lithographic printing plate precursor (1) expect for changing Polymerizable compound B-3 in Photosensitive layer (1) to Polymerizable compound B-4 described hereinbefore.

### [Preparation of Lithographic printing plate precursor (5)]

Lithographic printing plate precursor (5) was prepared in the same manner as in Lithographic printing plate precursor (1) expect for changing Polymerizable compound B-3 in Photosensitive layer (1) to Polymerizable compound B-5 described hereinbefore.

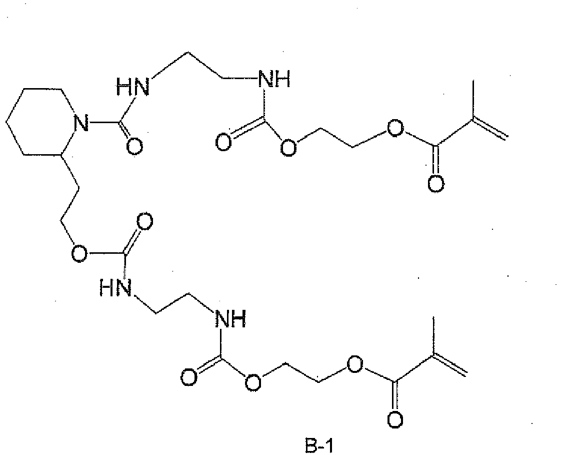

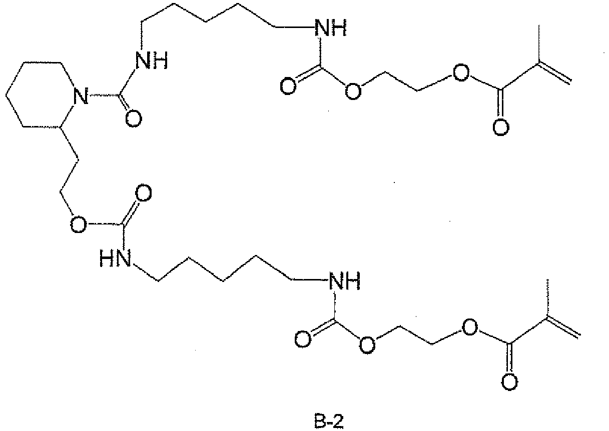

### (1) Exposure, Development and Printing

Each of Lithographic printing plate precursors (1) to (5) was subjected to image exposure by a violet semiconductor laser plate setter Vx9600 (having InGaN semiconductor laser: emission: 405 nm ± 10 nm/output, 30 mW) produced by FUJIFILM Electronic Imaging, Ltd. As for the image, halftone dots of 50% were drawn using an FM screen (TAFFETA 20, produced by FUJIFILM Corp.) in a plate surface exposure amount of 0.05 mJ/cm² and at resolution of 2,438 dpi.

The exposed lithographic printing plate precursor was then subjected to development processing in an automatic development processor having a structure shown in Fig. 1 using each of Processing solutions 1 to 51 having the composition shown below at transporting speed so as to have pre-heating time of 10 seconds at 100°C and immersion time (developing time) in the developer (having temperature of 25°C) of 20 seconds. The plate surface temperature immediately after passing the drying unit was controlled so as to be 40°C which was determined by noncontact measurement using a radiation thermometer. The heating time (time necessary for passing through the drying unit) was 7.4 seconds.

The lithographic printing plate obtained by the development processing was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dainippon Ink & Chemicals, Inc.).

### <Processing solutions 1 to 35>

| | |
|---|---|
| Water | X g |
| Compound (E) | Y g |
| Compound (F) | Z g |
| Nonionic Surfactant (W-1) shown below | 2.4 g |
| Nonionic Surfactant (W-2) shown below | 2.4 g |
| Nonionic Surfactant (EMALEX 710, produced by Nihon Emulsion Co., Ltd.) | 1.0 g |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |
| Polystyrenesulfonic acid (VERSA TL77 (30% by weight solution), produced by Alco Chemical Inc.) | 1.0 g |

The pH was adjusted to 7.0 by adding sodium hydroxide and phosphoric acid.

### <Processing solutions 48 to 51>

Processing solutions 48 to 51 were prepared in the same manner as in Processing solution 29 except for changing the amount of water to 89.2 g and changing the nonionic surfactants to 5.8 g of the surfactant shown in Table 3, respectively. The pH of each of Processing solutions 48 to 51 was also adjusted to 7.0.

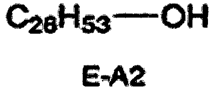

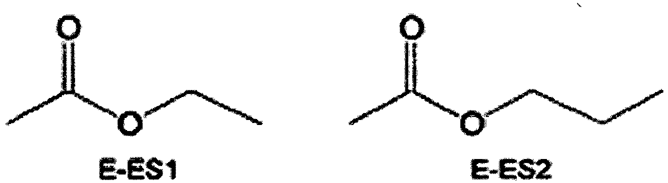

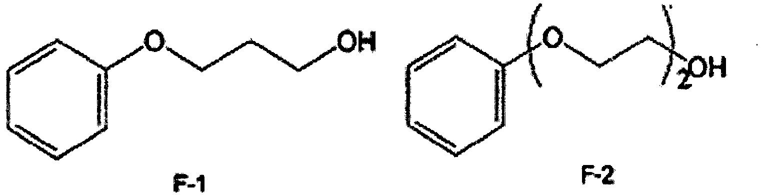

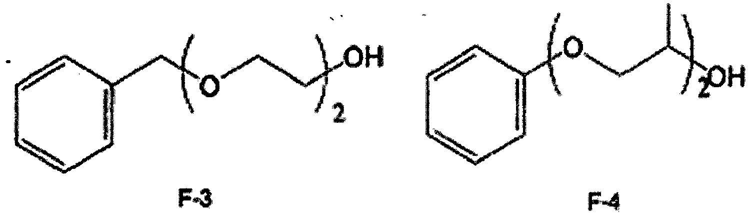

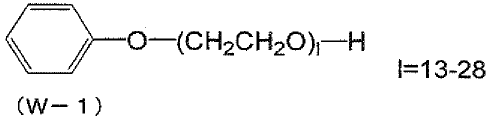

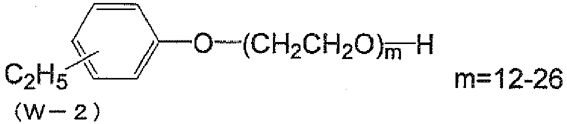

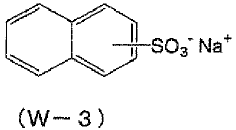

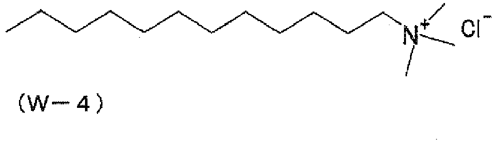

### (2) Evaluation

### <Phase separation of processing solution>

One day after the preparation of the processing solution (1 kg), the processing solution was visually evaluated according to the criteria described below.
A: Phase separation was not observed.
B: Phase separation was slightly observed.
C: Phase separation was severely observed.

The criterion B is in an acceptable level. The results obtained are shown in the tables below.

### <Odor>

The lithographic printing plate precursor was subjected to the image exposure and development processing as described above and after the drying, odor of the resulting lithographic printing plate was evaluated. Specifically, the odor was evaluated using sensory testing (whether the odor was strongly recognized or it was not disturbing) by 10 operators and the case where 7 or more of the 10 operators recognized that the odor was not disturbing was regard as an acceptable level. The number of the operators who evaluated that the odor was not disturbing and acceptable is shown in the tables below.

### <Stickiness of printing plate and processing bath>

After the lithographic printing plate precursor was subjected to development processing using the automatic development processor as described above in an amount of 500 m², the stickiness of printing plate and processing bath were evaluated by 10 operators. The number of the operators who evaluated that the stickiness was not disturbing and acceptable is shown in the tables below.

The stickiness of printing plate was evaluated by touching with hand the surface of lithographic printing plate finally obtained after the processing of 500 m² of the lithographic printing plate precursor.

The stickiness of processing bath was evaluated by touching with hand a wall of the processing bath after the processing of 500 m² of the lithographic printing plate precursor, removing the processing solution from the processing bath and washing the processing bath with water.

The case where 7 or more of the 10 operators recognized that the stickiness was not disturbing was regarded as an acceptable level.

### <Sludge>

After the lithographic printing plate precursor was subjected to development processing using the automatic development processor as described above in an amount of 500 m², the generation of sludge on the bottom of the processing bath of the automatic development processor was observed and evaluated according to the criteria described below.
A: The generation of sludge was not observed.
B: The generation of sludge was slightly observed, but was in an acceptable level.
C: The generation of sludge was severe.

The results obtained are shown in the tables below.

### <Printing durability>

As increase in the number of printed materials, the image of the photosensitive layer formed on the lithographic printing plate was gradually abraded to cause decrease in the ink-receptive property, resulting in decrease in ink density of the image on a printing paper. A number of printed materials obtained until the ink density (reflection density) decreased by 0.1 from that at the initiation of printing was determined to evaluate the printing durability. The results obtained are shown in the tables below.

### <Developing property>

The lithographic printing plate precursor as shown in Table 3 was subjected to the development processing with the processing solution as shown in Table 3 and the developing property was visually evaluated according to the criteria described below.
A: Development proceeded to a level free from the residual layer.
B: Problems did no occur in the printing, although the thin residual layer was slightly present.
C: Development did not proceed at all or development slightly proceeded and the image density was somewhat decreased but the remaining layer was large.

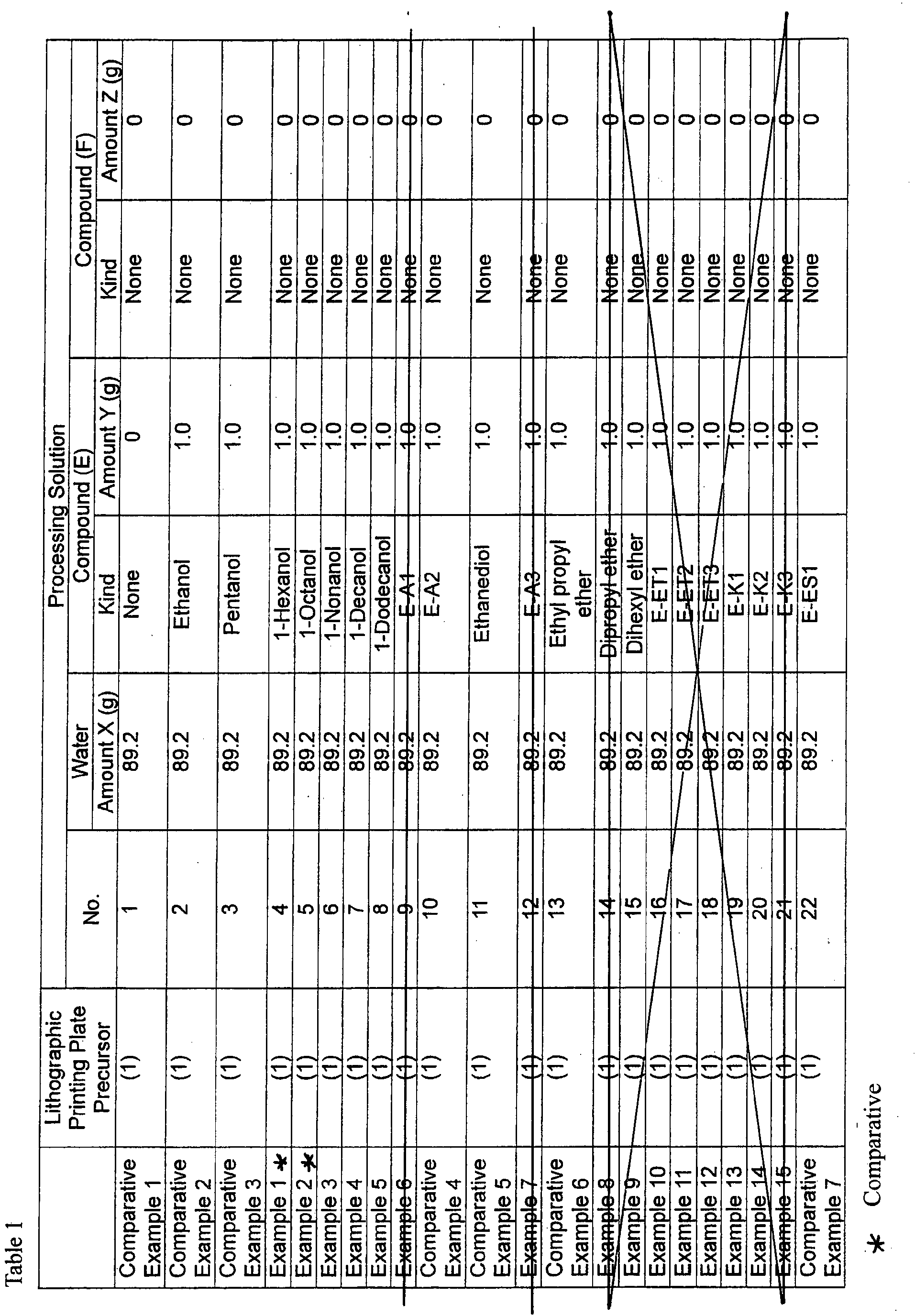

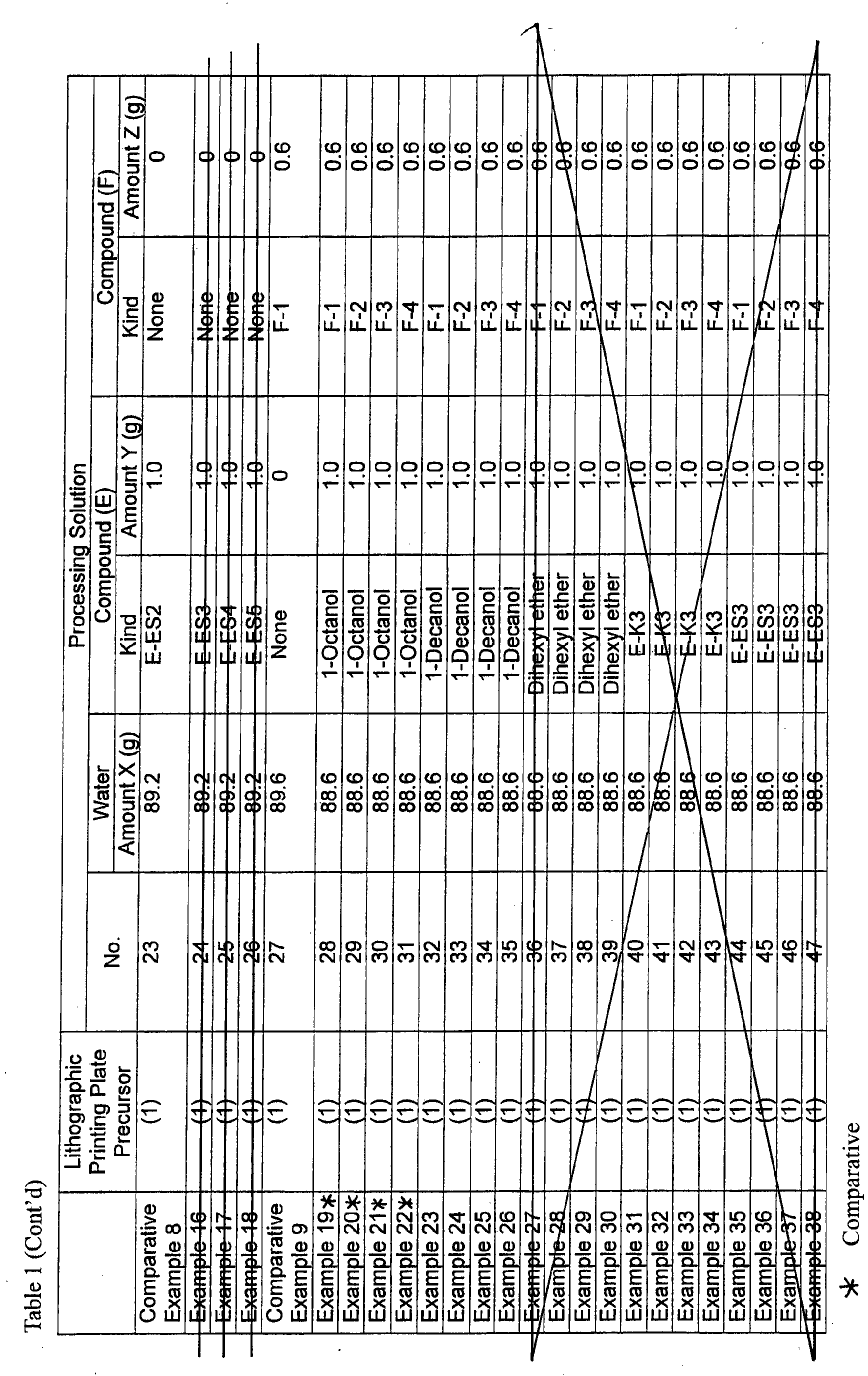

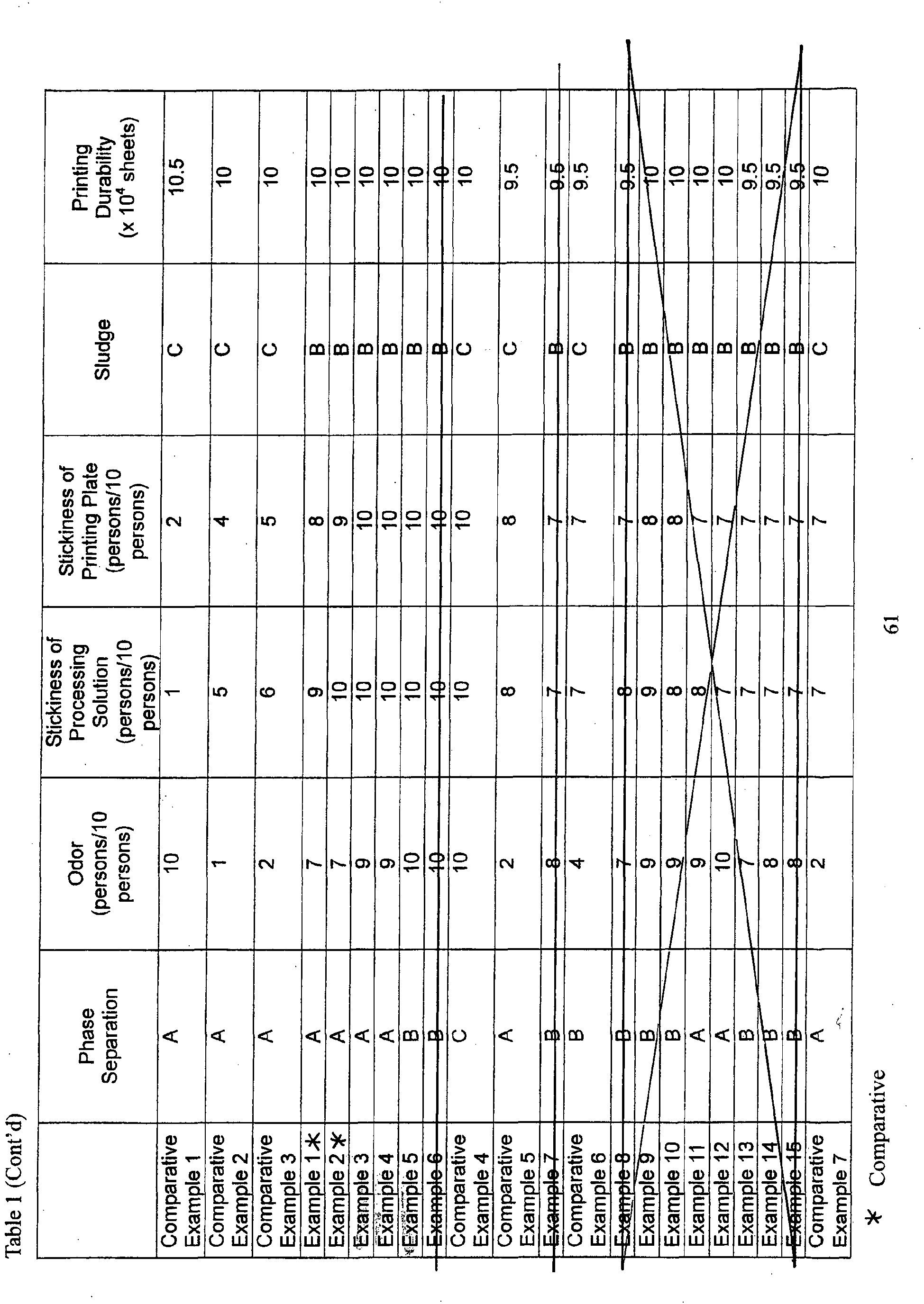

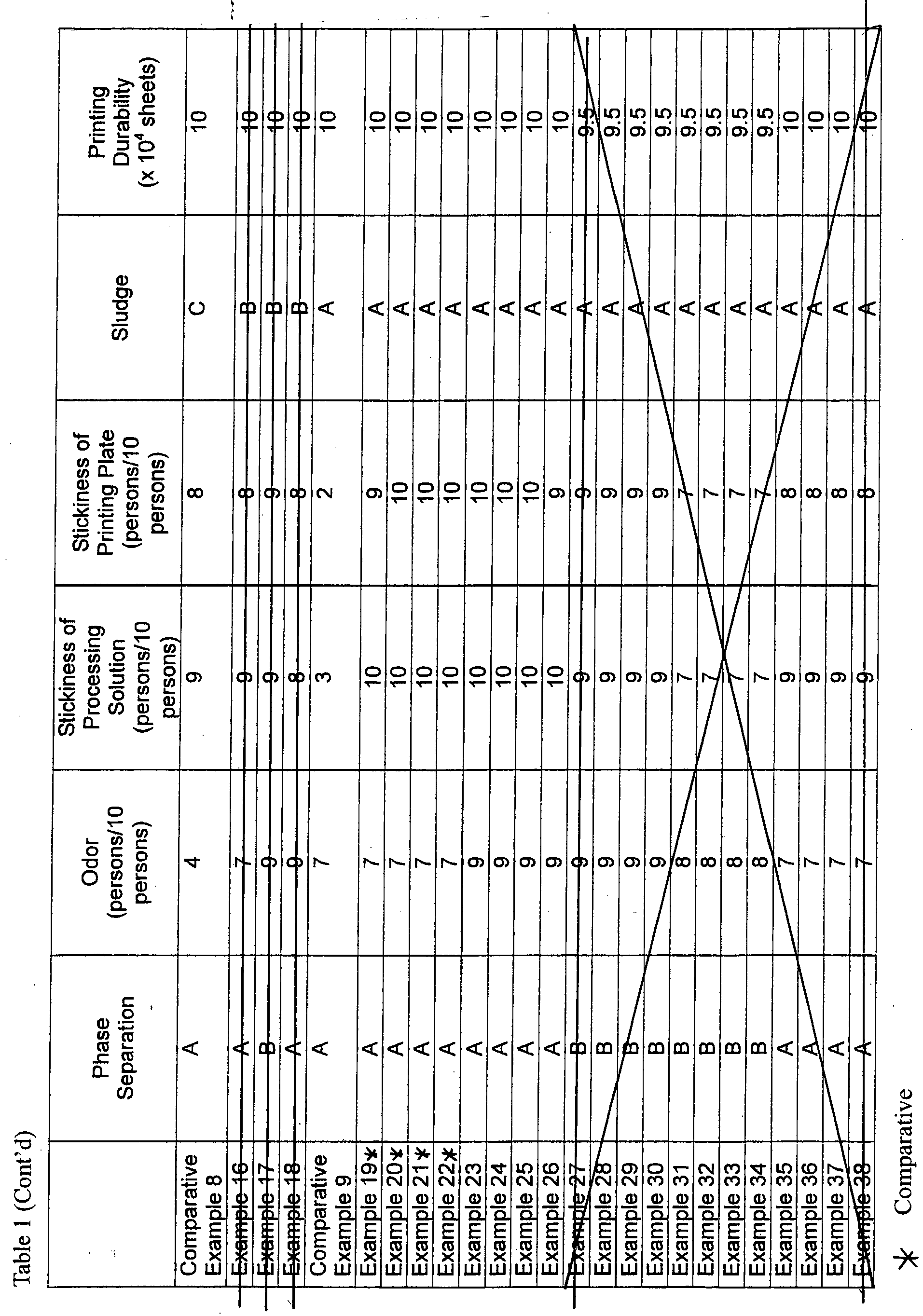

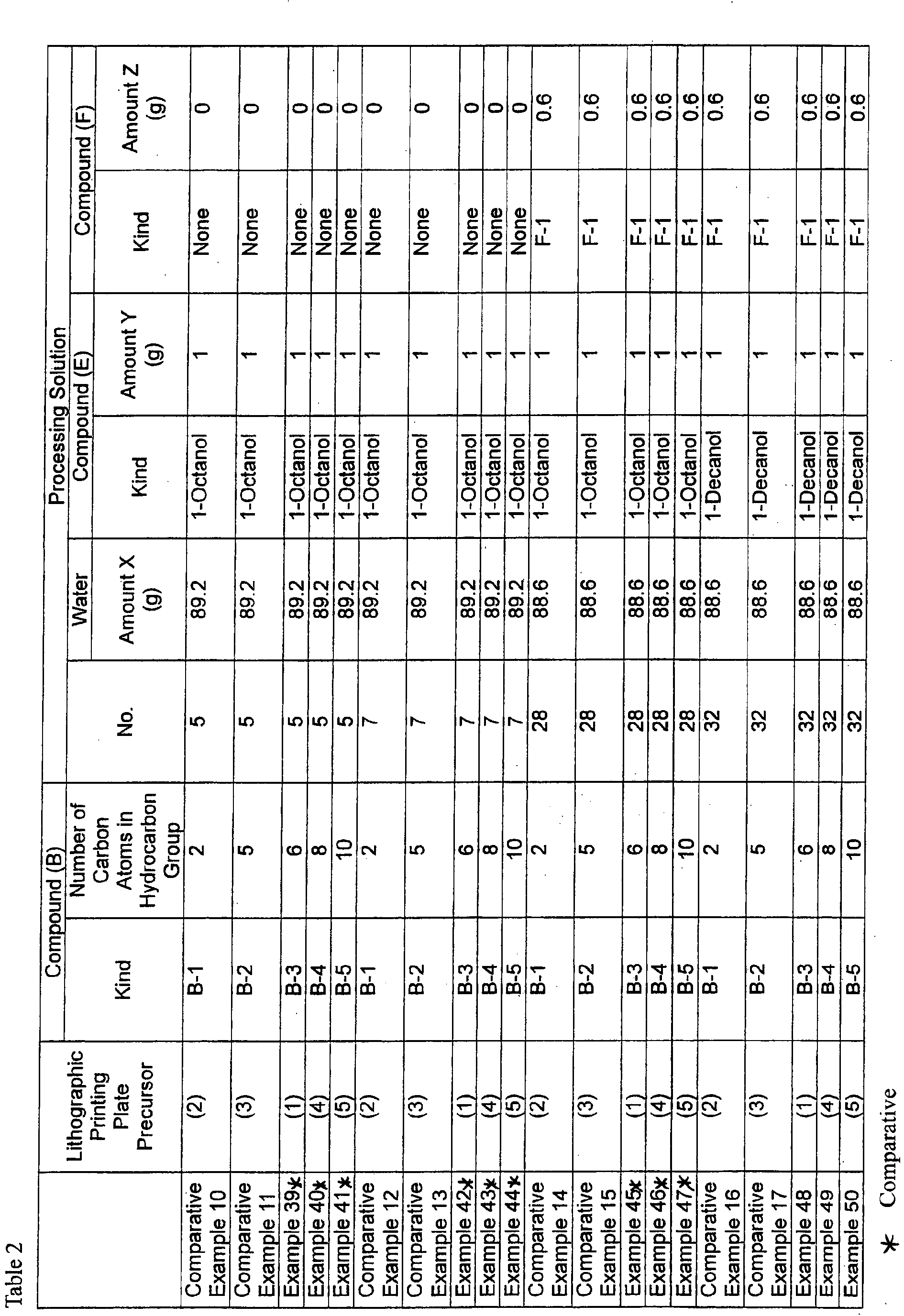

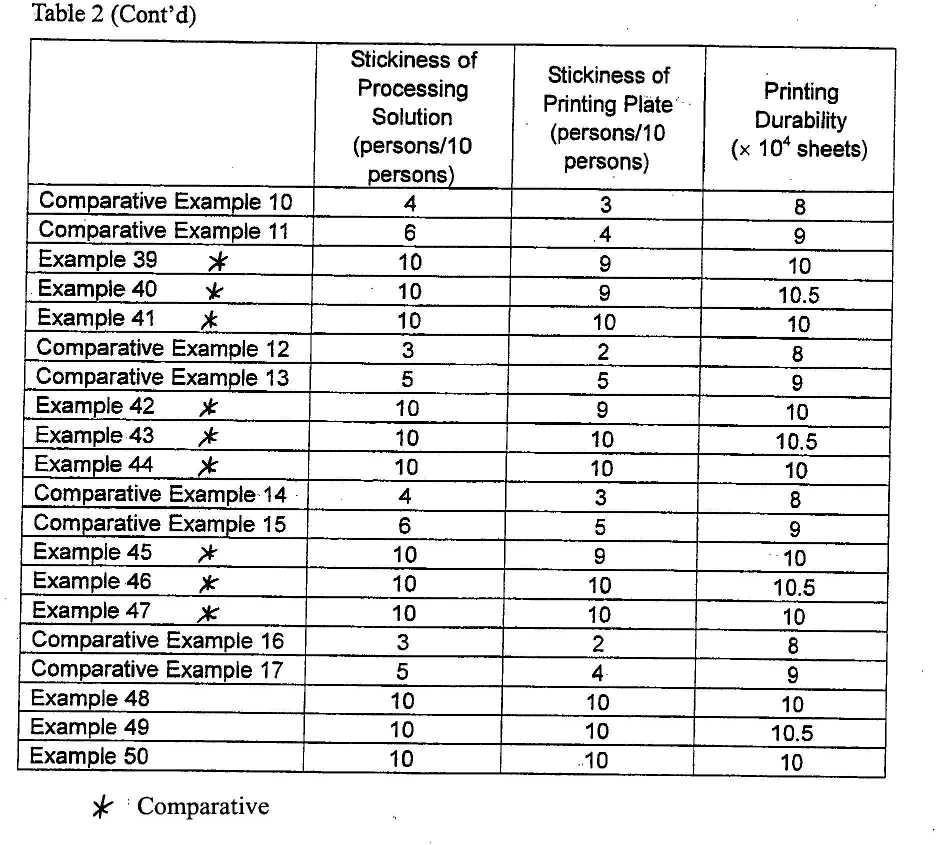

**Table 3**

| | Lithographic Printing Plate Precursor | Processing Solution | | Phase Separation | Developing Property |
|---|---|---|---|---|---|
| | | No. | Surfactant | | |
| Example 51 * | (1) | 48 | W-3 | B | B |
| Example 52 * | (1) | 49 | W-4 | B | B |
| Example 53 * | (1) | 50 | W-1 | A | A |
| Example 54 * | (1) | 51 | W-2 | A | A |
| Example 55 * | (1) | 29 | W-1,W-2 and EMALEX 710 | A | A |

| | | | | | |
|---|---|---|---|---|---|
| * Comparative | | | | | |

From the results shown in Table 1 to 3, it can be seen that the method of preparing a lithographic printing plate according to the invention prevents the occurrence of development scum, achieves a balance between good developing property and good printing durability, and is free from the odor generation.

### Examples 56 to 81 and Comparative Examples 18 to 26

Using Lithographic printing plate precursor (1) and Processing solutions 52 to 86, the evaluation was conducted in the same manner as in Examples 1 to 55 as shown in Table 4. The results obtained are shown in Table 4.

### <Processing solutions 52 to 86>

| | |
|---|---|
| Compound (E) | Y g |
| Compound (F) | Z g |
| Surfactant (1) (SOFTAZOLINE LPB-R, produced by Kawaken Fine Chemicals Co, Ltd.) | 15 g |
| Surfactant (2) (SOFTAZOLINE LAO, produced by Kawaken Fine Chemicals Co, Ltd.) | 4 g |
| Chelating agent: Trisodium ethylenediaminesuccinate (OCTAQUEST E30, produced by Innospec Specialty Chemicals Inc.) | 0.68 g |
| 2-Bromo-2-nitropropane-1,3-diol | 0.025 g |
| 2-Methyl-4-isothiazoline-3-one | 0.025 g |
| Silicone type deforming agent: (TSA 739, produced by GE Toshiba Silicone Co., Ltd.) | 0.15 g |
| Sodium gluconate | 1.5 g |
| Sodium carbonate | 1.06 g |
| Sodium hydrogen carbonate | 0.52 g |
| Water | 77.04 g |

The pH was adjusted to 9.8 by adding sodium hydroxide and phosphoric acid to the developer of the above composition. SOFTAZOLINE LPB-R 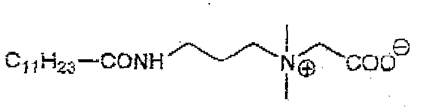 SOFTAZOLINE LAO

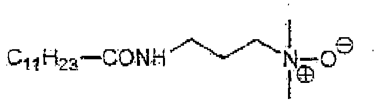

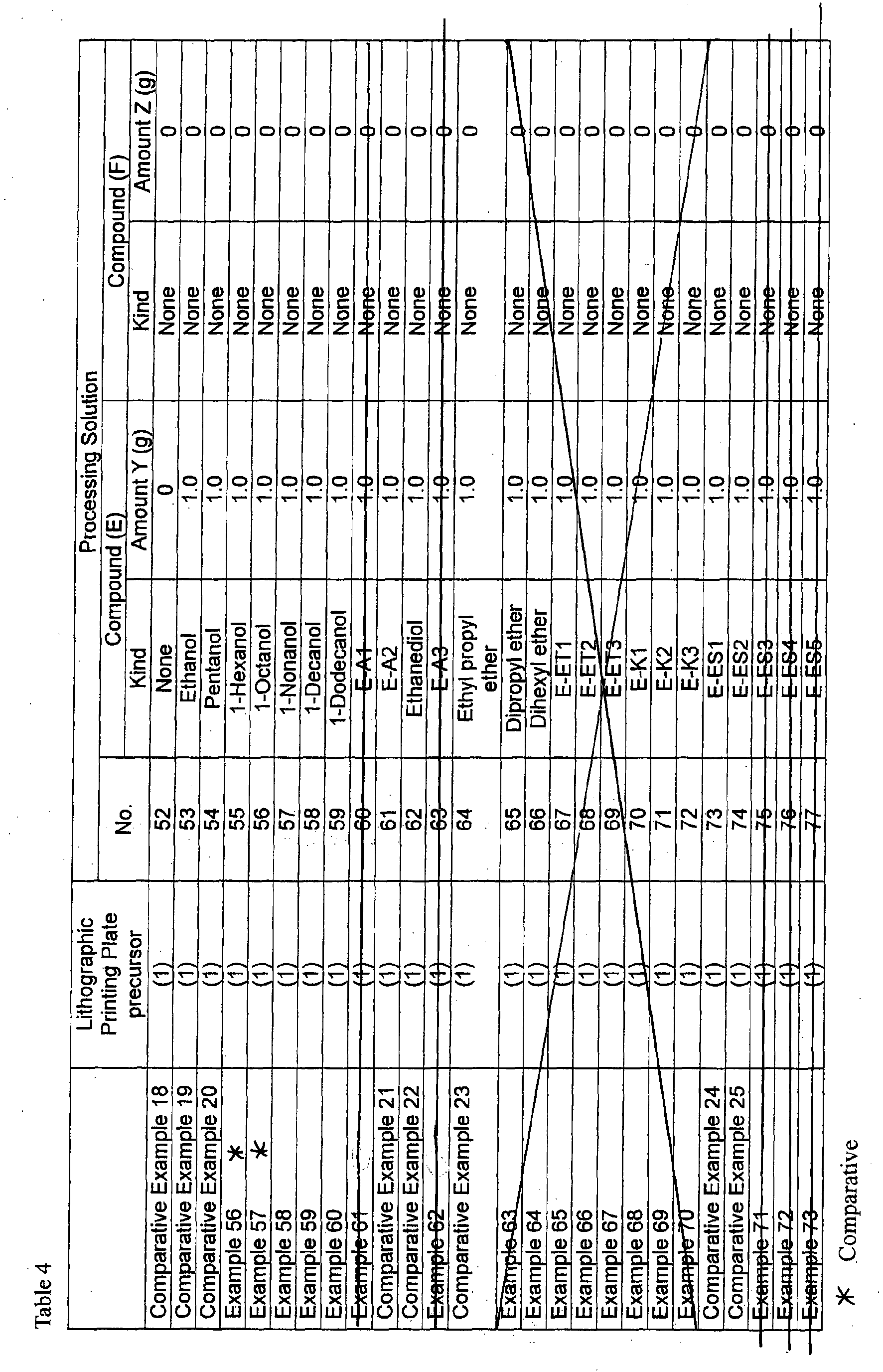

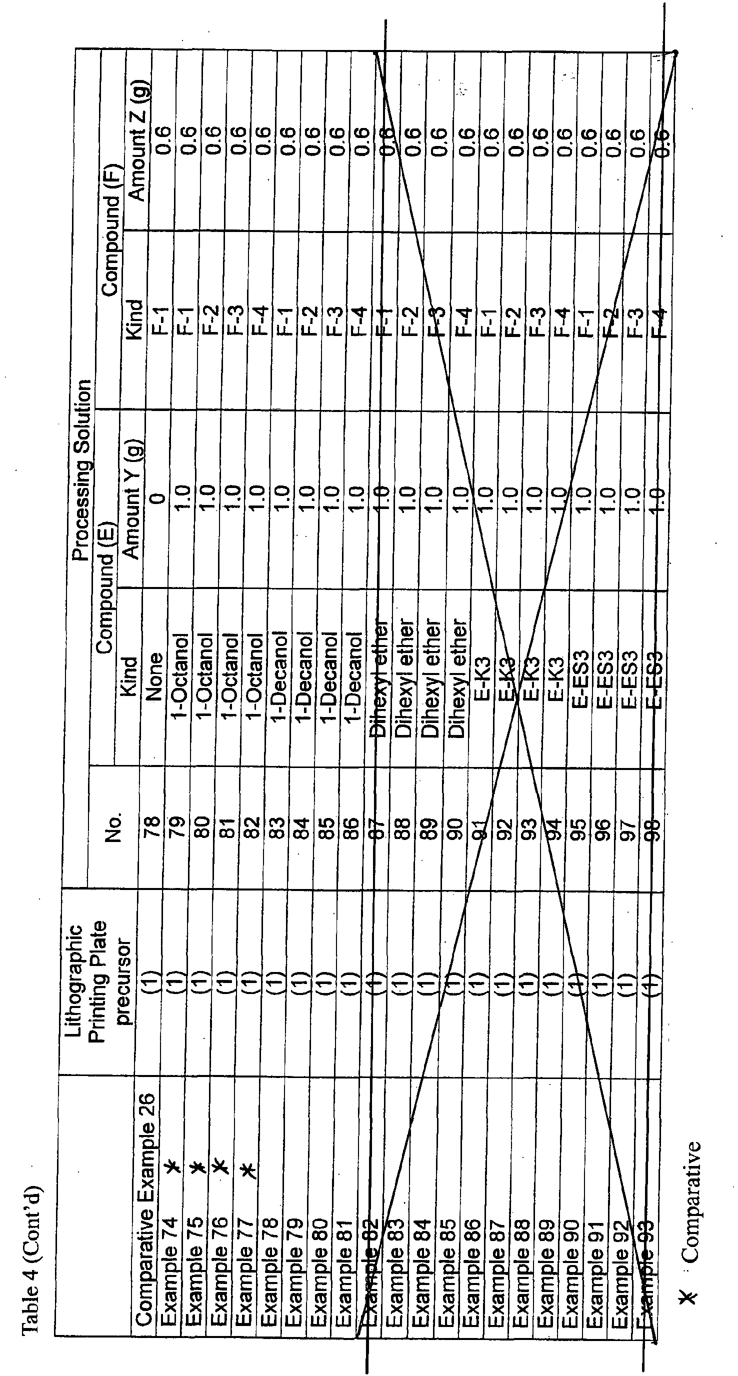

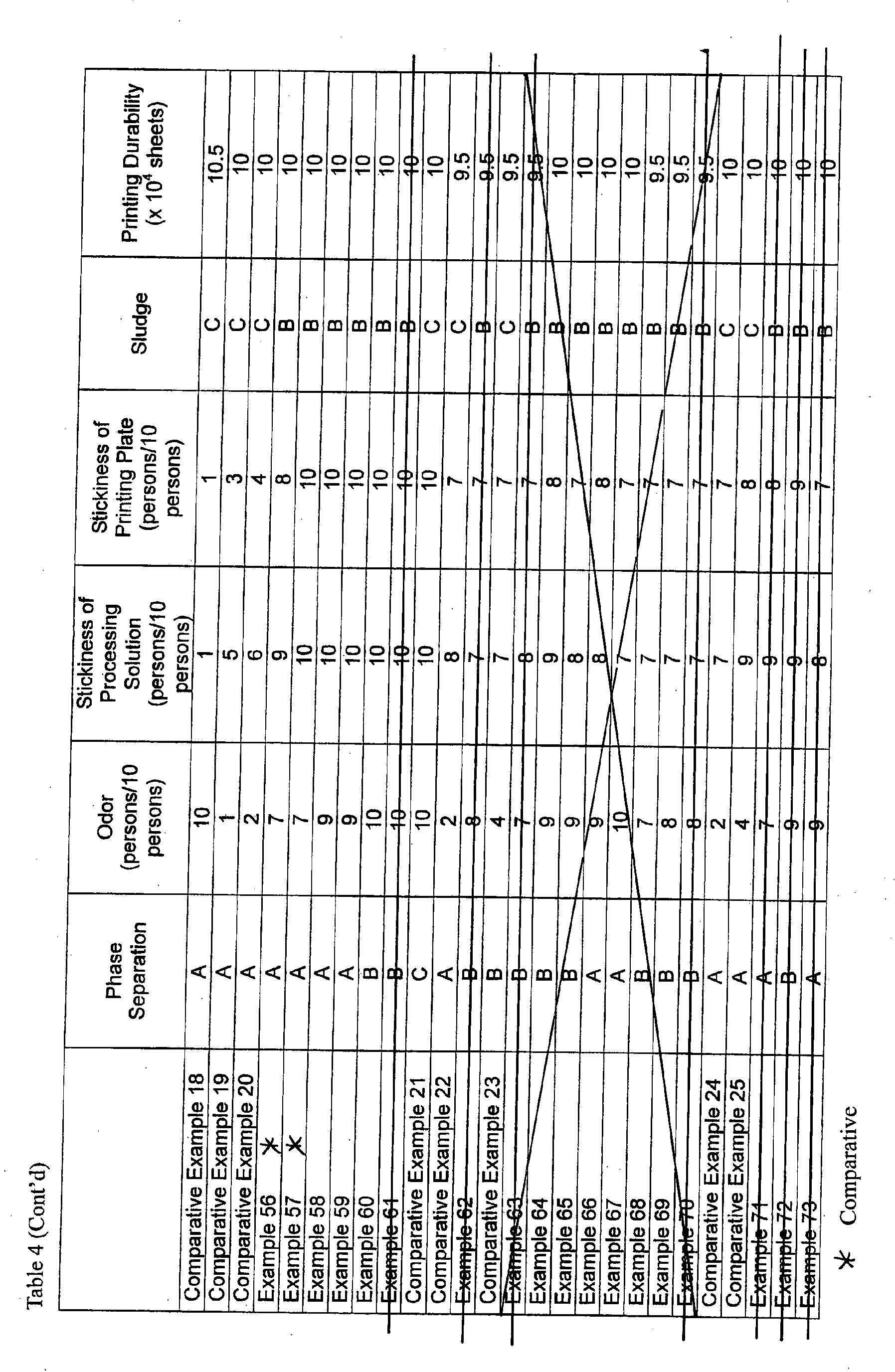

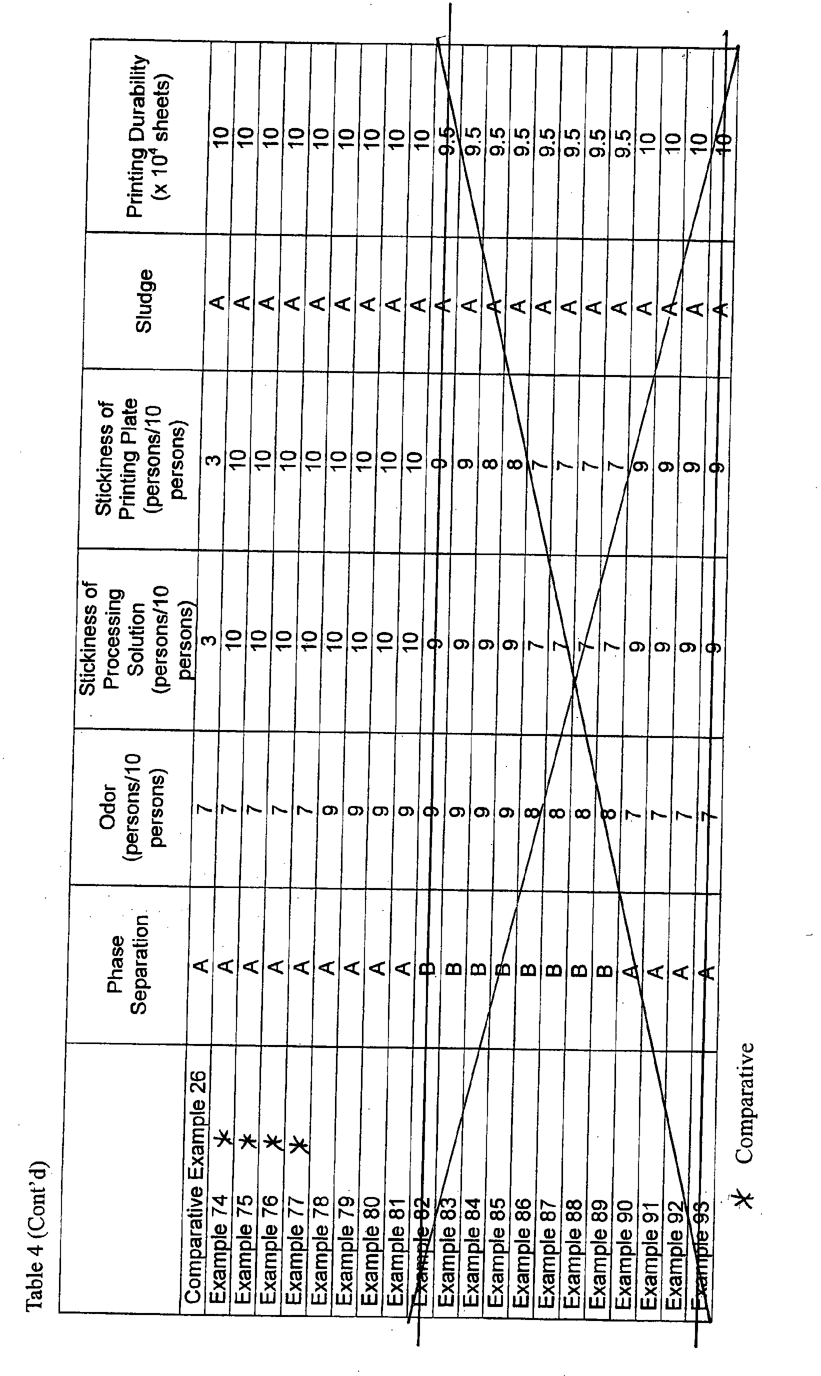

From the results shown in Table 4, it can be seen that the method of preparing a lithographic printing plate according to the invention prevents the occurrence of development scum, achieves a balance between good developing property and good printing durability, and is free from the odor generation, even when development with a weak alkaline developer containing a carbonate ion and a hydrogen carbonate ion is conducted

## Claims

1. A method of preparing a lithographic printing plate which comprises:
exposing imagewise a lithographic printing plate precursor comprising a hydrophilic support having provided thereon a photosensitive layer containing (A) a hexaarylbisimidazole compound, (B) a polymerizable compound having a hydrocarbon group having 6 or more carbon atoms in its molecule, (C) a sensitizing dye and (D) a binder polymer and a protective layer in this order using a laser, and
removing the protective layer and an unexposed area of the photosensitive layer of the exposed lithographic printing plate precursor using a processing solution having pH of 2 to 11 and which contains (E) an alcohol represented by formula (1) and (F) a compound represented by formula (III): 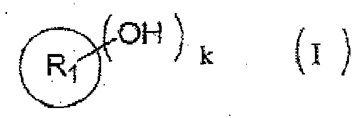 wherein R₁ represents a k-valent straight-chain, branched or cyclic aliphatic hydrocarbon group having from 9 to 12 carbon atoms, and k represents an integer of 1 or more; 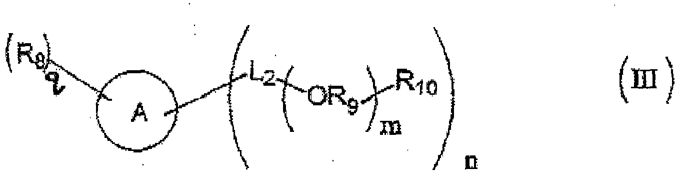 wherein A represents an aromatic ring, R₈ represents an alkyl group having from 1 to 3 carbon atoms, L₂ represents a single bond or an alkylene group having from 1 to 4 carbon atoms, R₉ represents an alkylene group having from 1 to 4 carbon atoms, R₁₀ represents a hydroxy group, an alkoxy group having from 1 to 4 carbon atoms, a phenoxy group or a naphthoxy group, m represents an integer of 0 to 4, q represents an integer of 0 to 5, and n represents an integer of 1 to 8, provided that q and n satisfy 1≤q+n≤8.

2. A method according to Claim 1, wherein R₉ is an alkylene group having 1 or 2 carbon atoms, or m represents an integer of 2 to 4.

3. A method according to Claim 1 or Claim 2, wherein the processing solution further comprises a nonionic surfactant.

4. A method according to any preceding Claim, wherein the weight ratio of compound (E) to the compound (F) is from 1:9 to 9:1.

5. A method according to any preceding Claim, wherein the processing solution further comprises carbonate ions and hydrogen carbonate ions.

6. A method according to any preceding Claim, wherein the processing solution further comprises a water-soluble organic amine compound or an ion thereof.

7. A method according to Claim 6, wherein the water-soluble organic amine compound is monoethanolamine, diethanolamine, triethanolamine, N-hydroxyethylmorpholine or 4-dimethylaminopyridine.

8. A method according to any preceding Claim, wherein a water washing step is not employed during the manufacture of the lithographic printing plate.

9. A method according to any preceding Claim, wherein after removing the protective layer and an unexposed area of the photosensitive layer using the processing solution, the lithographic printing plate precursor is dried by heating the plate precursor to have a plate surface temperature in the range of 25 to 80°C.

10. A method according to any preceding Claim, wherein the binder polymer (D) is a (meth)acrylic resin or a polyvinyl butyral resin.

11. A method according to any preceding Claim, wherein the protective layer contains one or more polyvinyl alcohols whose average degree of saponification is in the range of 70 to 93% by mol.

12. A method according to Claim 1, wherein the pH of the processing solution is from 5 to 10.7.

## Patentansprüche

1. Verfahren zur Herstellung einer Lithographiedruckplatte, welches umfasst:
bildweises Belichten eines Lithographiedruckplattenvorläufers, umfassend einen hydrophilen Träger, auf dem eine fotoempfindliche Schicht, enthaltend (A) eine Hexaarylbisimidazolverbindung, (B) eine polymerisierbare Verbindung, die eine Kohlenwasserstoffgruppe mit 6 oder mehr Kohlenstoffatomen in ihrem Molekül aufweist, (C) einen Sensibilisierungsfarbstoff und (D) ein Bindepolymer, und eine Schutzschicht in dieser Reihenfolge vorgesehen sind, unter Verwendung eines Lasers, und
Entfernen der Schutzschicht und eines nicht-belichteten Bereichs der fotoempfindlichen Schicht des belichteten Lithographiedruckplattenvorläufers unter Verwendung einer Verarbeitungslösung, die einen pH-Wert von 2 bis 11 aufweist und die (E) einen durch die Formel (I) dargestellten Alkohol und (F) eine durch die Formel (III) dargestellte Verbindung enthält: 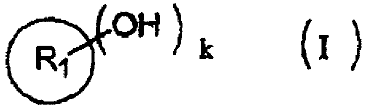 worin R₁ eine k-valente geradkettige, verzweigte oder cyclische, aliphatische Kohlenwasserstoffgruppe mit 9 bis 12 Kohlenstoffatomen darstellt und k eine ganze Zahl von 1 oder größer darstellt; 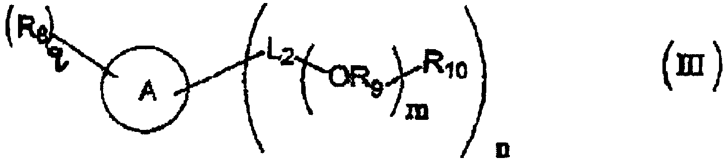 worin A einen aromatischen Ring darstellt, R₈ eine Alkylgruppe mit 1 bis 3 Kohlenstoffatomen darstellt, L₂ eine Einfachbindung oder eine Alkylengruppe mit 1 bis 4 Kohlenstoffatomen darstellt, R₉ eine Alkylengruppe mit 1 bis 4 Kohlenstoffatomen darstellt, R₁₀ eine Hydroxygruppe, eine Alkoxygruppe mit 1 bis 4 Kohlenstoffatomen, eine Phenoxygruppe oder eine Naphthoxygruppe darstellt, m eine ganze Zahl von 0 bis 4 darstellt, q eine ganze Zahl von 0 bis 5 darstellt und n eine ganze Zahl von 1 bis 8 darstellt, vorausgesetzt, dass q und n 1≤q+n≤8 erfüllen.

2. Verfahren gemäß Anspruch 1, worin R₉ eine Alkylengruppe mit 1 oder 2 Kohlenstoffatomen ist oder m eine ganze Zahl von 2 bis 4 darstellt.

3. Verfahren gemäß Anspruch 1 oder Anspruch 2, worin die Verarbeitungslösung ferner ein nicht-ionisches Tensid umfasst.

4. Verfahren gemäß irgendeinem vorstehenden Anspruch, worin das Gewichtsverhältnis der Verbindung (E) zu der Verbindung (F) von 1:9 bis 9:1 beträgt.

5. Verfahren gemäß irgendeinem vorstehenden Anspruch, worin die Verarbeitungslösung ferner Carbonationen und Hydrogencarbonationen umfasst.

6. Verfahren gemäß irgendeinem vorstehenden Anspruch, worin die Verarbeitungslösung ferner eine wasserlösliche organische Aminverbindung oder ein Ion hiervon umfasst.

7. Verfahren gemäß Anspruch 6, worin die wasserlösliche organische Aminverbindung Monoethanolamin, Diethanolamin, Triethanolamin, N-Hydroxyethylmorpholin oder 4-Dimethylaminopyridin ist.

8. Verfahren gemäß irgendeinem vorstehenden Anspruch, worin während der Herstellung der Lithographiedruckplatte kein Wasserwaschschritt eingesetzt wird.

9. Verfahren gemäß irgendeinem vorstehenden Anspruch, worin nach dem Entfernen der Schutzschicht und eines nicht-belichteten Bereichs der fotoempfindlichen Schicht unter Verwendung der Verarbeitungslösung der Lithographiedruckplattenvorläufer durch Erwärmen des Plattenvorläufers auf eine Plattenoberflächentemperatur im Bereich von 25 bis 80°C getrocknet wird.

10. Verfahren gemäß irgendeinem vorstehenden Anspruch, worin das Bindepolymer (D) ein (Meth)acrylharz oder ein Polyvinylbutyralharz ist.

11. Verfahren gemäß irgendeinem vorstehenden Anspruch, worin die Schutzschicht einen oder mehrere Polyvinylalkohol(e) enthält, dessen/deren mittlerer Verseifungsgrad im Bereich von 70 bis 93 mol% liegt.

12. Verfahren gemäß Anspruch 1, worin der pH-Wert der Verarbeitungslösung von 5 bis 10,7 beträgt.

## Revendications

1. Procédé de préparation d'une plaque d'impression lithographique qui comprend :
l'exposition pour former une image d'un précurseur de plaque d'impression lithographique comprenant un support hydrophile présentant sur celui-ci une couche photosensible contenant (A) un composé d'hexaarylbisimidazole, (B) un composé polymérisable contenant un groupe hydrocarboné ayant 6 atomes de carbone ou plus dans sa molécule, (C) un colorant sensibilisateur et (D) un polymère liant et une couche protectrice dans cet ordre en utilisant un laser, et
le retrait de la couche protectrice et d'une zone non exposée de la couche photosensible du précurseur de plaque d'impression lithographique exposé en utilisant une solution de traitement ayant un pH de 2 à 11 et qui contient (E) un alcool représenté par la formule (I) et (F) un composé représenté par la formule (III) : 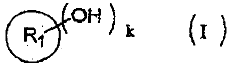 dans laquelle R₁ représente un groupe hydrocarboné aliphatique à chaîne linéaire, ramifié ou cyclique k-valent ayant de 9 à 12 atomes de carbone, et k représente un nombre entier de 1 ou plus ; 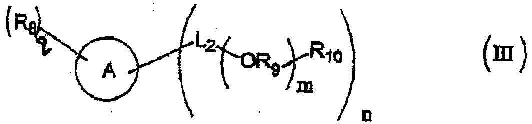 dans laquelle A représente un cycle aromatique, R₈ représente un groupe alkyle ayant de 1 à 3 atomes de carbone, L₂ représente une liaison simple ou un groupe alkylène ayant de 1 à 4 atomes de carbone, R₉ représente un groupe alkylène ayant de 1 à 4 atomes de carbone, R₁₀ représente un groupe hydroxy, un groupe alcoxy ayant de 1 à 4 atomes de carbone, un groupe phénoxy ou un groupe naphtoxy, m représente un nombre entier de 0 à 4, q représente un nombre entier de 0 à 5, et n représente un nombre entier de 1 à 8, dans la mesure où q et n satisfont 1 ≤ q + n ≤ 8.

2. Procédé selon la revendication 1, dans lequel R₉ est un groupe alkylène ayant 1 ou 2 atomes de carbone, ou m représente un nombre entier de 2 à 4.

3. Procédé selon la revendication 1 ou la revendication 2, dans lequel la solution de traitement comprend en outre un tensioactif anionique.

4. Procédé selon une quelconque revendication précédente, dans lequel le rapport en poids du composé (E) au composé (F) est de 1:9 à 9:1.

5. Procédé selon une quelconque revendication précédente, dans lequel la solution de traitement comprend en outre des ions carbonate et des ions hydrogénocarbonate.

6. Procédé selon une quelconque revendication précédente, dans lequel la solution de traitement comprend en outre un composé d'amine organique hydrosoluble ou un ion de celui-ci.

7. Procédé selon la revendication 6, dans lequel le composé d'amine organique hydrosoluble est la monoéthanolamine, la diéthanolamine, la triéthanolamine, la N-hydroxyéthylmorpholine ou la 4-diméthylaminopyridine.

8. Procédé selon une quelconque revendication précédente, dans lequel une étape de lavage à l'eau n'est pas utilisée pendant la fabrication de la plaque d'impression lithographique.

9. Procédé selon une quelconque revendication précédente, dans lequel après le retrait de la couche protectrice et d'une zone non exposée de la couche photosensible en utilisant la solution de traitement, le précurseur de plaque d'impression lithographique est séché par chauffage du précurseur de plaque pour avoir une température de surface de plaque dans la plage de 25 à 80 °C.

10. Procédé selon une quelconque revendication précédente, dans lequel le polymère liant (D) est une résine (méth)acrylique ou une résine de butyral de polyvinyle.

11. Procédé selon une quelconque revendication précédente, dans lequel la couche protectrice contient un ou plusieurs alcools polyvinyliques dont le degré de saponification moyen se situe dans la plage de 70 à 93 % en moles.

12. Procédé selon la revendication 1, dans lequel le pH de la solution de traitement est de 5 à 10,7.
